# EUROPEAN PATENT SPECIFICATION

(11) **EP 3 379 276 B1**
(45) Date of publication and mention of the grant of the patent: **13.05.2020**
(21) Application number: 18160273.1
(22) Date of filing: 06.03.2018
(51) Int. Cl.: G01R 31/319

(54) **HARDWARE TESTING DEVICE AND HARDWARE TESTING METHOD**
HARDWARE-TEST-VORRICHTUNG UND HARDWARE-TEST-VERFAHREN
DISPOSITIF DE TEST DE MATÉRIEL ET PROCÉDÉ DE TEST DE MATÉRIEL

(30) Priority: 23.03.2017 JP 2017058250
(43) Date of publication of application: 26.09.2018
(73) Proprietor: Hitachi, Ltd., Chiyoda-ku, Tokyo 100-8280 (JP)
(72) Inventor: SAKURAI, Soki, Chiyoda-ku, Tokyo 1008280 (JP); NISHIDA, Toshio, Chiyoda-ku, Tokyo 1008280 (JP)
(74) Representative: Mewburn Ellis LLP

(56) References cited:
- US-A- 5 844 909
- US-A1- 2008 234 967
- US-A1- 2015 067 629
- US-B1- 6 205 559
- US-B1- 6 707 313

## Description

### TECHNICAL FIELD

The present invention relates to a hardware testing device and a hardware testing method, and can be suitably applied to a hardware testing device and a hardware testing method for creating test plans and performing fault analysis in the testing of hardware.

### BACKGROUND ART

Conventionally, as a testing method of a semiconductor integrated circuit, known is the "fault dictionary" method of performing a fault injection simulation and creating data for identifying the cause in advance in order to identify the fault in the circuit.

With the fault dictionary method, a fault dictionary is created by assigning a plurality of input patterns to the circuit in a state where various faults have been injected into the circuit and acquiring the circuit output pattern during the fault (fault output pattern) in the advance simulation. By creating this kind of fault dictionary in advance, if an ideal output pattern could not be obtained in the actual test (real machine test), it will be possible to identify the fault by referring to the fault output pattern in the advance simulation in the fault dictionary. For example, when it is discovered that a predetermined output pattern differs from an ideal value in a simulation in which a predetermined fault has been injected, if there is any abnormality in the foregoing predetermined output pattern in the real machine test, it is possible to deduce that a fault corresponding to the foregoing predetermined output pattern (that is, the foregoing predetermined fault) has occurred.

A method of performing fault analysis by measuring the influence on the test result from the cause (fault) as with the fault dictionary method described above is known as the Cause-Effect method. The Cause-Effect method is effective for the fault analysis of general hardware without limitation to semiconductor integrated circuits. When using the Cause-Effect method in the fault analysis of general hardware, for instance, by preparing a plurality of test items and analyzing in advance the influence on the test pass/fail during fault injection, it is possible to identify the fault from the test pass/fail pattern during the actual test. For example, PTL 1 discloses an inspection method of shortening the test time as much as possible in an inspection device for inspecting semiconductor devices.

### CITATION LIST

### [PATENT LITERATURE]

[PTL 1] Japanese Patent Application Publication No. H7-181228
[PTL 2] US Patent Application No. 6,707,313 B1 discloses systems and methods for testing integrated circuits
[PTL 3] US Patent Application No. 2008/0234967 A1 discloses test sequence optimization method and design tool
[PTL 4] US Patent Application No. 5,844,909 discloses test pattern selection method for testing of integrated circuit

### SUMMARY OF THE INVENTION

### PROBLEMS TO BE SOLVED BY THE INVENTION

Meanwhile, in the case of using the Cause-Effect method in the fault analysis of hardware as described above, when a plurality of test items are executed in the hardware and the fault candidates are to be refined based on the test pass/fail patterns, this will be based on the premise that all test items can be executed and that all test pass/fail patterns can be obtained. Nevertheless, under circumstances with the existence of potential faults, when a specific operation is performed, there is a possibility that an abnormal input is made to other components and a secondary fault is generated. As a simple example, when the power is turned on in a case where the fuse is welded (in the state of a primary fault), there is a possibility that a damage will occur in the circuit positioned in front of the fuse (occurrence of a secondary fault).

Accordingly, in the fault analysis of hardware, in order to complete all test items in the state of a primary fault, there was problem in that it was necessary to give consideration to the order of executing the tests, and proceed with the tests while excluding the possibility of a secondary fault. For example, while the inspection method disclosed in PTL 1 is able to choose the order and items of the tests capable of maximizing the test efficiency while giving consideration to the coverage of the test object with regard to a plurality of test items, because no consideration is given to the influence on the test object from the test execution, it cannot necessarily be said that the tests can be continued safely, and it was necessary to additionally examine the test order in the test object that could encounter a secondary fault.

The present invention was devised in view of the foregoing points, and an object of this invention is to propose a hardware testing device and a hardware testing method capable of completing the series of tests while minimizing the possibility of a secondary fault, even in the existence of a primary fault, in the testing of hardware.

### MEANS TO SOLVE THE PROBLEMS

In order to resolve the foregoing problems, the present invention provides a hardware testing device as set forth in claim 1.

Moreover, in order to resolve the foregoing problems, the present invention additionally provides a hardware testing method as set forth in claim 10.

### ADVANTAGEOUS EFFECTS OF THE INVENTION

According to the present invention, it is possible to minimize the possibility of a secondary fault, even in the existence of a primary fault, in the testing of hardware.

### BRIEF DESCRIPTION OF DRAWINGS

[Fig. 1] Fig. 1 is a diagram showing a hardware configuration example of the hardware testing device according to the first embodiment of the present invention.
[Fig. 2] Fig. 2 is a diagram showing a functional configuration example of the hardware testing device illustrated in Fig. 1.
[Fig. 3] Fig. 3 is a diagram explaining an example of the test list.
[Fig. 4] Fig. 4 is a diagram explaining an example of the fault list.
[Fig. 5] Fig. 5 is a diagram explaining an example of the fault injection test result table.
[Fig. 6] Fig. 6 is a diagram explaining an example of the test priority table.
[Fig. 7] Fig. 7 is a diagram explaining an example of the real machine test result table.
[Fig. 8] Fig. 8 is a flowchart showing an example of the processing routine of the test selection processing.
[Fig. 9] Fig. 9 is a flowchart showing an example of the processing routine of the real machine test processing.
[Fig. 10] Fig. 10 is a flowchart showing an example of the processing routine of the fault candidate refinement processing.
[Fig. 11] Fig. 11 is a flowchart showing an example of the processing routine of the test priority table creation processing.
[Fig. 12] Fig. 12 is a flowchart showing an example of the processing routine of the test priority determination processing.
[Fig. 13] Fig. 13 is a diagram explaining an example of the fault test candidate table.
[Fig. 14] Fig. 14 is a diagram explaining an example of the test priority table in a second round test.
[Fig. 15] Fig. 15 is a diagram explaining an example of the display screen of an output device.
[Fig. 16] Fig. 16 is a diagram explaining an example of the fault injection test result table used in the second embodiment.
[Fig. 17] Fig. 17 is a flowchart showing an example of the processing routine of the test priority table creation processing in the second embodiment.
[Fig. 18] Fig. 18 is a flowchart showing an example of the processing routine of the test priority determination processing in the second embodiment.
[Fig. 19] Fig. 19 is a diagram explaining an example of the test priority table in the second embodiment.

### DESCRIPTION OF EMBODIMENTS

An embodiment of the present invention is now explained in detail with reference to the appended drawings.

### (1) First embodiment

### (1-1) Hardware configuration

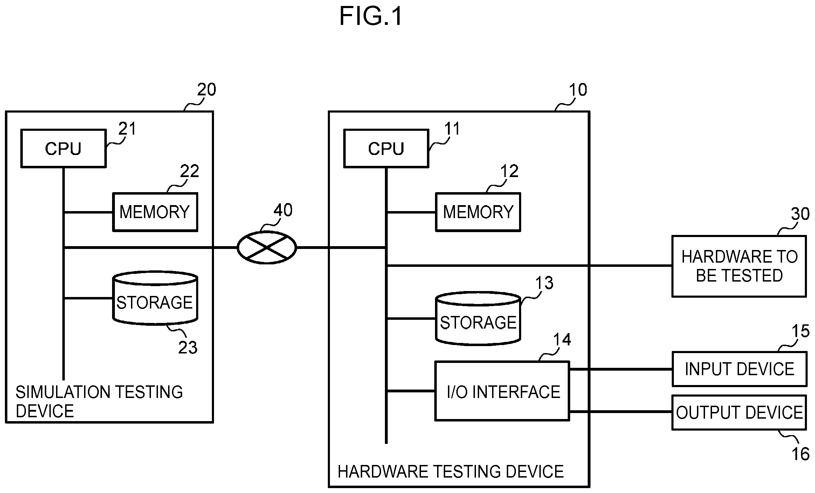

Fig. 1 is a diagram showing a hardware configuration example of the hardware testing device according to the first embodiment of the present invention. Fig. 1 shows a hardware testing device 10 according to the first embodiment of the present invention, a simulation testing device 20 which executes test cases by using a simulator or the like, and hardware to be tested 30 to be subject to the real machine test. The hardware testing device 10 is communicably connected to the simulation testing device 20 via a network 40. Moreover, the hardware testing device 10 is also communicably connected to the hardware to be tested 30.

In Fig. 1, the hardware testing device 10 is configured by comprising a CPU (Central Processing Unit) 11, a memory 12, a storage 13, and an I/O interface 14. The CPU 11, the memory 12, the storage 13, and the I/O interface 14 are mutually connected via a bus configured from a CPU bus or the like. The hardware testing device 10 can be realized, for example, from a personal computer (PC) or another computer.

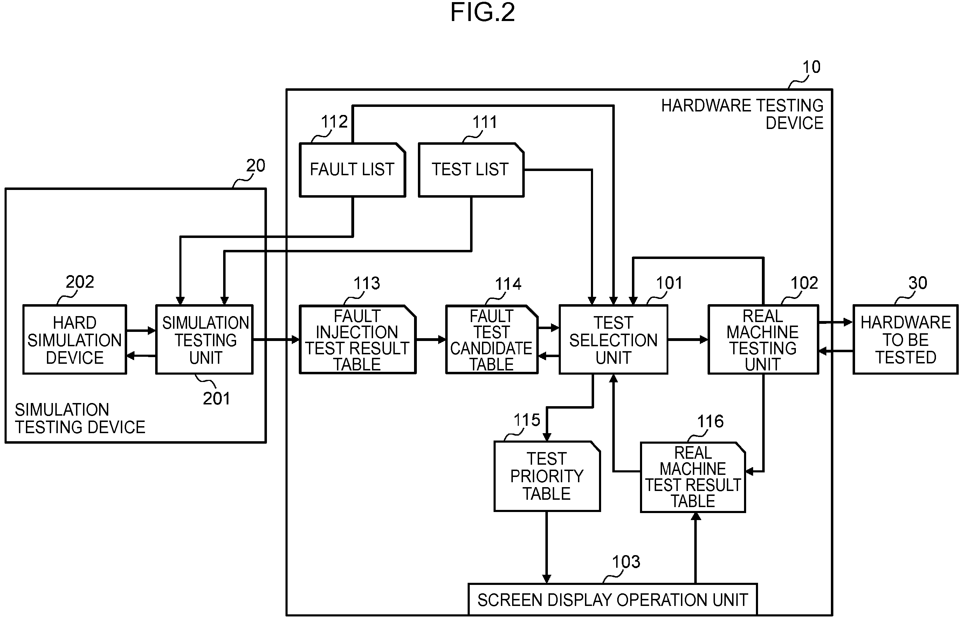

The CPU 11 functions as an arithmetic processing unit and a control unit, and controls the overall operation within the hardware testing device 10 according to various programs. The CPU 11 may also be a micro processor. The test selection unit 101, the real machine testing unit 102, and the screen display operation unit 103 shown in Fig. 2 described later are realized by the CPU 11 executing one or more predetermined programs.

The memory 12 temporarily stores programs to be executed by the CPU 11 and parameters to be suitably changed in the execution of such programs. The storage 13 stores programs and arithmetic parameters to be used by the CPU 11. The test list 111, the fault list 112, the fault injection test result table 113, the fault test candidate table 114, the test priority table 115, and the real machine test result table 116 shown in Fig. 2 described later are stored as data in the memory 12 or the storage 13.

The I/O interface 14 is a device of a standard capable of connecting the hardware testing device 10 and peripheral equipment, and connects the hardware testing device 10 with an input device 15 and an output device 16. The input device 15 is a device such as a keyboard or a mouse to which the user can perform input operations, and the operations input to the input device 15 are transmitted to the CPU 11 via the I/O interface 14. Moreover, the output device 16 is a device such as a display or a printer which becomes the output destination of the hardware testing device 10, and, when an output instruction is given from the CPU 11 (in terms of function, the screen display operation unit 103), output such as a screen display or printing is performed by the target output device 16 via the I/O interface 14. In the ensuing explanation, the output device 16 is explained as a display terminal (display) capable of displaying images.

Note that the hardware testing device 10 of Fig. 1 illustrates the main parts of the hardware configuration of the hardware testing device according to this embodiment, and the configuration thereof is not limited to the example illustrated in Fig. 1. For example, the configuration may be such that the input device 15 and the output device 16 are equipped within the hardware testing device 10, or a configuration that is not illustrated in Fig. 1 may also be added. Moreover, the hardware testing device according to the present invention is not limited to a type configured from one computer (hardware testing device 10) as shown in Fig. 1, and may also be configured by a plurality of computers being linked.

The simulation testing device 20 can also be configured from a personal computer (PC) or another computer in the same manner as the hardware testing device 10. The simulation testing device 20 comprises a CPU 21, a memory 22, and a storage 23. The simulation testing unit 201 and the hardware simulation device 202 shown in Fig. 2 described later are realized by the CPU 21 executing one or more predetermined programs by using the data stored in the memory 22 and the storage 23. More specifically, the simulation testing unit 201 is realized so that simulation tests of test cases can be executed in the hardware simulation device 202. Note that the hardware simulation device 202 will suffice so as long as it is able to simulate the hardware to be tested 30, and is realized with a software simulator or the like, but otherwise, for example, a simulated hardware circuit or the like may also be used as a substitute. Moreover, the configuration corresponding to the simulation testing device 20 may also be built into the hardware testing device 10.

The hardware to be tested 30 is the hardware to be actually subject to the hardware test conducted by the hardware testing device 10. While the details will be described later, when the implementation of a predetermined test case is instructed from the hardware testing device 10 in a real machine test, the hardware to be tested 30 executes the instructed test case, and notifies the execution result to the hardware testing device 10. Note that the hardware to be tested 30 may also undergo the execution of the real machine test based on the user's operations.

### (1-2) Functional configuration

Fig. 2 is a diagram showing a functional configuration example of the hardware testing device illustrated in Fig. 1.

As shown in Fig. 2, the hardware testing device 10 comprises the functional configurations of a test selection unit 101, a real machine testing unit 102, and a screen display operation unit 103. Moreover, the simulation testing device 20 comprises the functional configurations of a simulation testing unit 201 and a hardware simulation device 202.

In this embodiment, prior to the processing performed by the hardware testing device 10, a simulation test is performed as pre-processing in the simulation testing device 20. Specifically, the simulation testing unit 201 uses the hardware simulation device 202, which is a simulator for simulating the hardware to be tested 30, and executes a test case in the state of a fault, and acquires the test result of the test case. Note that, as also explained with reference to Fig. 1, the configuration corresponding to the simulation testing device 20 may also be built into the hardware testing device 10, and, in such a hardware configuration, the simulation testing unit 201 and the hardware simulation device 202 become the functional configurations in the hardware testing device 10. The configuration may also be such that only the hardware simulation device 202 is provided outside the hardware testing device 10, and the simulation testing unit 201 is equipped within the hardware testing device 10.

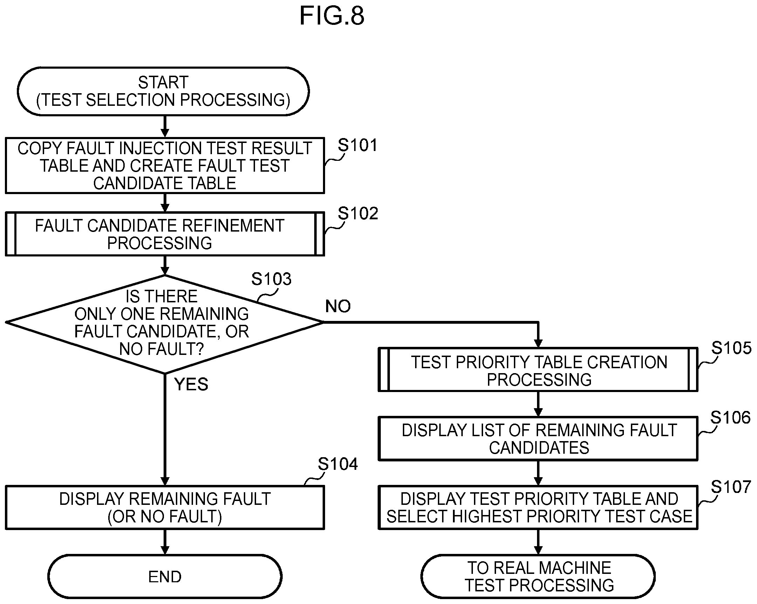

Furthermore, in the hardware testing device 10 shown in Fig. 2, the test selection unit 101 performs the test selection processing of assigning a priority to unexecuted test cases based on the test results of the simulation tests conducted by the simulation testing device 20 and the latest test results of the real machine tests conducted by the real machine testing unit 102 regarding the plurality of test cases to be executed in the hardware to be tested 30, and selecting the test case in which the real machine test is to be subsequently executed. Note that, in the test selection processing, the test selection unit 101 assigns a higher priority to the test cases from the test case having the lowest probability of encountering a secondary fault. Details of the test selection processing will be explained later with reference to Fig. 8 and other diagrams.

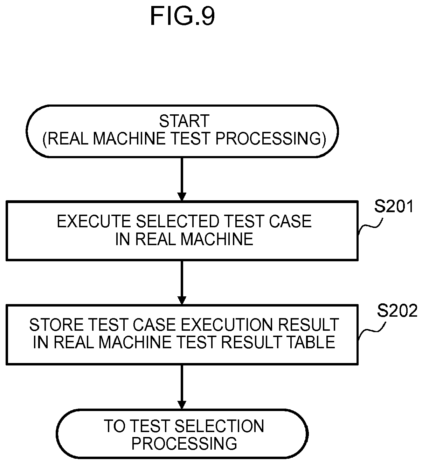

Moreover, based on the selection result of the test case by the test selection unit 101, the real machine testing unit 102 performs the real machine test processing of causing the hardware to be tested 30 to execute the foregoing test case (that is, the test case with the highest priority). Details of the real machine test processing will be described later with reference to Fig. 9.

In the hardware testing device 10, as a result of the test selection processing performed by the test selection unit 101 and the real machine test processing performed by the real machine testing unit 102 being alternately and repeatedly executed, it is possible to execute the series of real machine tests while minimizing the possibility of the occurrence of a secondary fault regarding the plurality of test cases.

Moreover, the screen display operation unit 103 performs the screen display processing of displaying to the user the result of repeating the processing performed by the test selection unit 101 and the real machine testing unit 102 as described above. Furthermore, when a predetermined operation is performed by the user in response to the displayed screen, the screen display operation unit 103 can also perform processing corresponding to the user's operation.

Note that, within the hardware testing device 10 illustrated in Fig. 2, shown are a test list 111, a fault list 112, a fault injection test result table 113, a fault test candidate table 114, a test priority table 115, and a real machine test result table 116. These are input/output data used in the processing performed by each of the foregoing functional configurations (test selection unit 101, real machine testing unit 102, screen display operation unit 103, simulation testing unit 201), and are respectively in a list format or a table format.

In the ensuing explanation, the foregoing input/output data will be explained in detail by listing specific examples while offering a brief explanation regarding the related processing of each of the functional configurations.

The test list 111 is a list which stores information indicating a list of the test cases to be executed in the hardware to be tested 30.

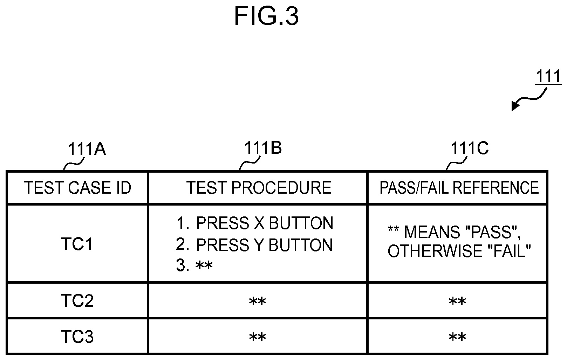

Fig. 3 is a diagram explaining an example of the test list. As shown in Fig. 3, the test list 111 is stored in a table format, and each test case is configured from a test case ID 111A, a test procedure 111B, and a pass/fail criterion 111C.

The test case ID 111A is a name (identifier) capable of uniquely identifying the test case. The test procedure 111B describes the execution procedures of the target test case. While Fig. 3 shows the hardware operation to be performed manually by the user as one example, as other examples, for instance, a script that can be executed by software may also be indicated. Moreover, let it be assumed that the test procedure 111B also includes the preconditions related to the execution of the target test case. The pass/fail criterion 111C describes the criterion for determining whether the test result of the target test case is "Pass" or "Fail" after the test procedure 111B is executed. Note that the pass/fail criterion 111C may also indicate a script in which software can automatically determine Pass/Fail based on automatic processing similar to the test procedure 111B.

The fault list 112 is a list which stores information indicating the list of faults that may be encountered in the hardware to be tested 30. Note that the faults stored in the fault list 112 are primary faults.

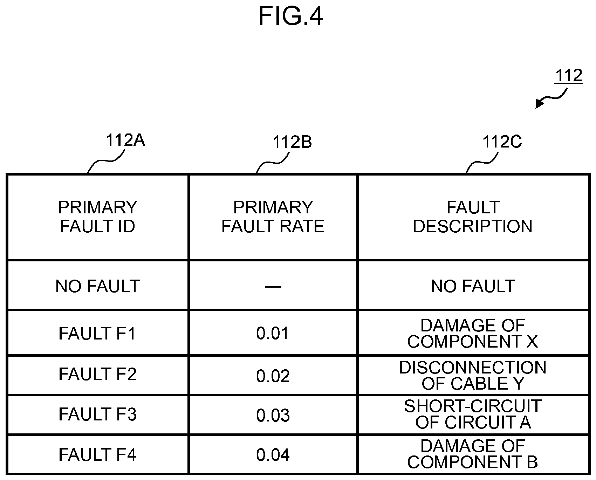

Fig. 4 is a diagram explaining an example of the fault list. Similar to the test list 111 of Fig. 3, the fault list 112 of Fig. 4 is also shown in a table format. As shown in Fig. 4, the fault list 112 is configured, for each primary fault, from a primary fault ID 112A, a primary fault rate 112B, and a fault description 112C. Note that the faults (primary faults) registered in the fault list 112 are not limited to the faults of components in the hardware, and may also include man-caused faults such as mounting errors and wiring errors of components.

The primary fault ID 112A is a name (identifier) capable of uniquely identifying the target primary fault. The primary fault rate 112B indicates the probability that the target primary fault will occur. Specifically, for instance, in the case of a fault in the component, a value disclosed by the component manufacturer may be used, or, in the case of a man-caused fault, a value calculated from past history may be used. In the example shown in Fig. 4, the unit of the fault rate is not displayed in percentage, but rather displayed as a dimensionless quantity. The foregoing dimensionless quantity may be displayed because, with the primary fault rate 112B, it will be sufficient so as long as the fault rates between the plurality of primary faults (F1 to F4) registered in the fault list 112 can be relatively compared. Furthermore, the fault description 112C describes the details of the target primary fault.

Let it be assumed that the test list 111 illustrated in Fig. 3 and the fault list 112 illustrated in Fig. 4 are created in advance and stored in the hardware testing device 10 (for example, storage 13). Moreover, the test list 111 and the fault list 112 are also sent to the simulation testing unit 201 in advance. As described above, in the simulation testing device 20, prior to the processing performed by the hardware testing device 10, the simulation testing unit 201 uses the hardware simulation device 202 to perform a simulation test as prerequisite processing by using the test list 111 and the fault list 112.

More specifically, the simulation testing unit 201 executes each test case registered in the test list 111 in a state where the primary fault registered in the fault list 112 has been injected into the hardware simulation device 202 (that is, in a state of "primary fault"). Subsequently, the simulation testing unit 201 sends the fault injection test result table 113 storing the execution result to the hardware testing device 10, and the hardware testing device 10 stores the received fault injection test result table 113 in the storage 13 or the like.

The fault injection test result table 113 is a table which stores information indicating the result of the simulation test conducted by the simulation testing unit 201. Note that, as described above, because the simulation test to be conducted by the simulation testing unit 201 is performed as the pre-processing of the processing to be performed by the test selection unit 101, the fault injection test result table 113 is already complete at the time that the test selection processing to be performed by the test selection unit 101 is started.

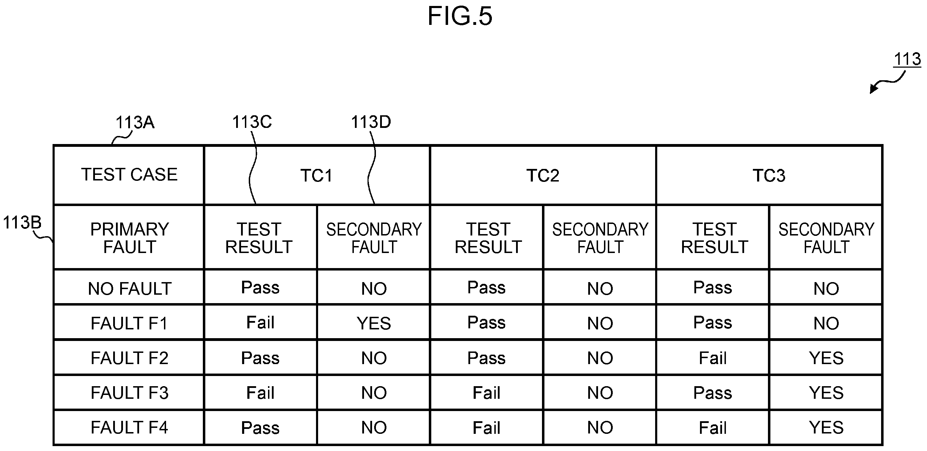

Fig. 5 is a diagram explaining an example of the fault injection test result table. In Fig. 5, each column of the fault injection test result table 113 indicates the test case that underwent the simulation test (test case 113A). In the case shown in Fig. 5, the test case 113A is indicated as the test case ID (TC1 to TC3) shown in the test case ID 111A of the test list 111. Moreover, each line of the fault injection test result table 113 shows the primary fault that was set in the simulation test (primary fault 113B). In the case shown in Fig. 5, the primary fault 113B is indicated as the primary fault ID (no fault, fault F1 to fault F4) shown in the primary fault ID 113A of the fault list 112. Furthermore, Fig. 5 is provided with a test result 113C and a secondary fault 113D as information indicating the results of the simulation tests that were conducted based on the combination of the test case 113Aand the primary fault 113B. The test result 113C indicates the test result (Pass/Fail) of the simulation result based on the pass/fail criterion 111C of the test list 111. The secondary fault 113D indicates "Yes" or "No" regarding whether or not a secondary fault occurred in the simulation test.

The creation (recording) of the fault injection test result table 113 by the simulation testing unit 201 is now explained in further detail.

The simulation testing unit 201 executes the series of test cases (TC1 to TC3) stored in the test list 111 in the hardware simulation device 202, which is a simulation of the hardware to be tested 30. Here, the simulation testing unit 201 executes the foregoing test cases (TC1 to TC3) in a state where each primary fault (no fault, fault F1 to F4) registered in the fault list 112 is injected one by one into the hardware simulation device 202, and determines whether the test result is "Pass" or "Fail" based on the pass/fail criterion 111C indicated in the test list 111. Furthermore, the simulation testing unit 201 records the determined test result in the test result 113C of the fault injection test result table 113.

Furthermore, the simulation testing unit 201 checks the state of the hardware simulation device 202 upon executing the respective test cases (TC1 to TC3), and confirms whether or not any fault (that is, secondary fault) other than the injected primary fault has occurred. Here, if a secondary fault has occurred, "Yes" is recorded in the secondary fault 113D of the fault injection test result table 113, and, if a secondary fault has not occurred, "No" is recorded in the secondary fault 113D of the fault injection test result table 113.

As a result of the foregoing processing being performed, the simulation testing unit 201 is able to complete the fault injection test result table 113. Upon reviewing the specific test results illustrated in Fig. 5, for example, when the test case of TC2 is executed in a state in which a fault F1 is injected, because the test result 113C is "Pass" and the secondary fault 113D is "No", this indicates that the test result is "Pass" without the occurrence of a secondary fault. Meanwhile, even in a state where the same fault F1 was injected, when the test case of TC1 is executed, because the test result 113C is "Fail" and the secondary fault 113D is "Yes", this indicates that the test result is "Fail" and a secondary fault has occurred.

Note that, in the foregoing explanation, while a case was explained where the simulation testing unit 201 creates the fault injection test result table 113 and sends the created fault injection test result table 113 to the hardware testing device 10, in this embodiment, the configuration may also be such that the simulation testing unit 201 sends the results of the simulation test to the hardware testing device 10 and the hardware testing device 10 on the receiving side (for example, test selection unit 101) creates and stores the fault injection test result table 113.

As a result of the prerequisite processing being performed by the simulation testing device 20 as described above, the hardware testing device 10 can obtain the fault injection test result table 113.

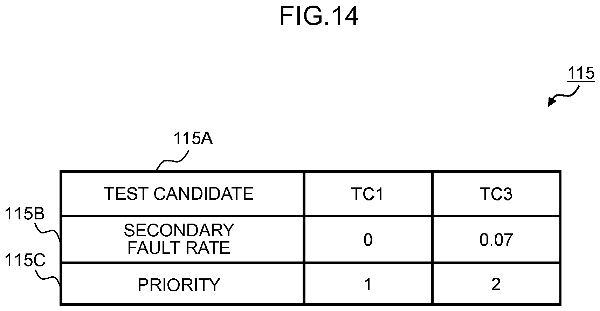

Furthermore, when the test selection unit 101 performs the test selection processing which determines the test priority of the test cases in the hardware testing device 10, the test selection unit 101 copies the entries of the fault injection test result table 113 and thereby creates the fault test candidate table 114. The fault test candidate table 114 is handled as temporary data while the test selection processing is performed by the test selection unit 101, and the contents thereof may be changed in association with the execution of the real machine test by the real machine testing unit 102. Details will be described later. As shown with the specific example of Fig. 14, the table configuration of the fault test candidate table 114 is basically the same as the table configuration of the fault injection test result table 113.

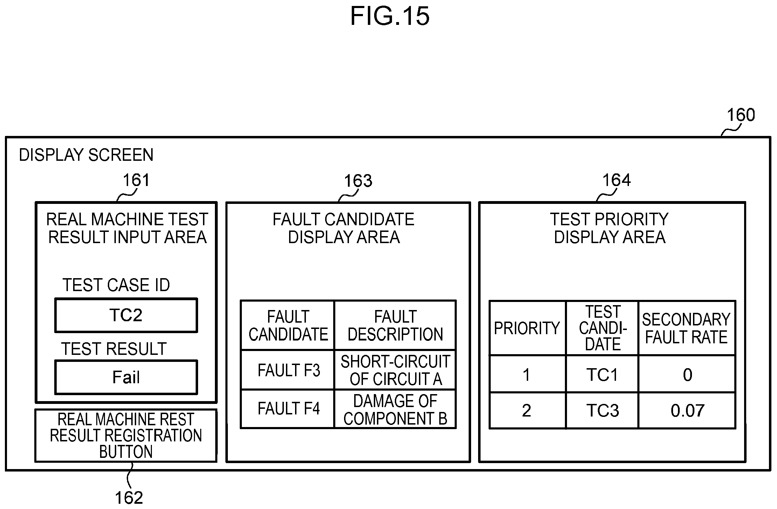

Furthermore, the test priority table 115 is created based on the test selection processing performed by the test selection unit 101. The test priority table 115 is a table which stores information indicating the priority related to the execution of the real machine test regarding the test cases to be executed in the hardware to be tested 30 (that is, test cases registered in the test list 111). Note that the test priority table 115 shows only the test cases which have not yet undergone the real machine test at such point in time. Among the foregoing test cases, the test case with the highest priority is determined as the test case to be executed in the subsequent real machine test. Moreover, information recorded in the test priority table 115 is also used for the output control by the screen display operation unit 103 (refer to Fig. 15).

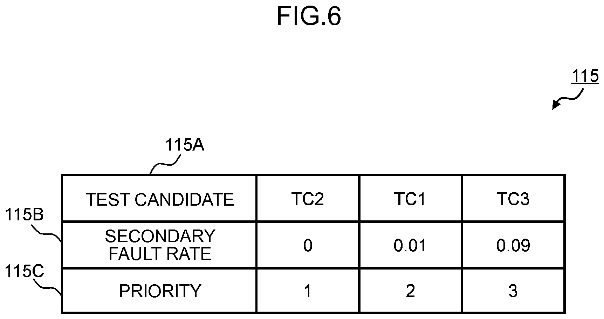

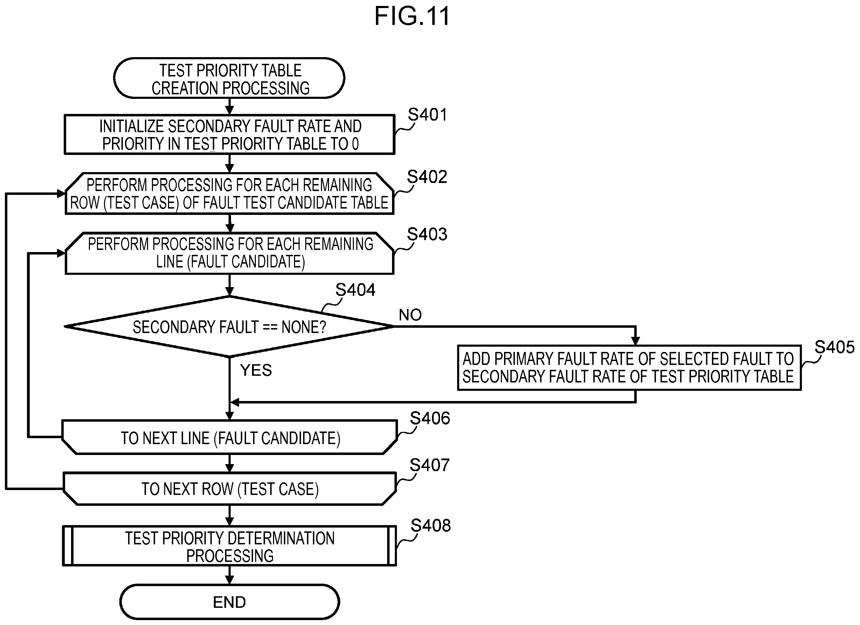

Fig. 6 is a diagram explaining an example of the test priority table. In Fig. 6, each column of the test priority table 115 indicates the test case that has not yet undergone a real machine test at such point in time (test candidate 115A). In the case shown in Fig. 6, the test candidate 115A is indicated as the test case ID (TC1 to TC3) shown in the test case ID 111A of the test list 111. The test priority table 115 stores, as information corresponding to each test candidate 115A, a secondary fault rate 115B which indicates the probability that a secondary fault will occur, and a priority 115C which indicates the priority in relation to the execution of the real machine test. Details of the creation processing of the test priority table 115 will be described later with reference to Fig. 11, but in the hardware testing device 10 according to the first embodiment, a higher priority is assigned to the test candidate with the lowest secondary fault rate. Specifically, for instance, in the case shown in Fig. 6, because the secondary fault rates of the test candidates TC1 to TC3 are respectively "0.01", "0", and "0.09", the priority of 1 to 3 is sequentially assigned in order from the lowest secondary fault rate; that is, in the order of TC2, TC1, TC3.

When the test priority table 115 is created by the test selection unit 101, the real machine testing unit 102 executes the real machine test in the hardware to be tested 30 regarding the test case with the highest priority among the test cases indicated in the test priority table 115. Subsequently, the real machine testing unit 102 stores, in the real machine test result table 116, the result of the real machine test executed in the hardware to be tested 30.

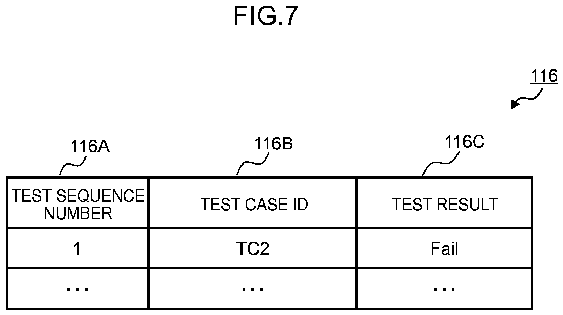

Fig. 7 is a diagram explaining an example of the real machine test result table. In Fig. 7, the real machine test result table 116 is configured from a test sequence number 116A, a test case ID 116B, and a test result 116C.

The test sequence number 116A is a number which indicates the order of the real machine tests (tests) to be executed, and is incrementally assigned for each execution of the test. The test case ID 116B indicates an identifier capable of identifying the test case executed in the real machine test, and is indicated as the test case ID (for example, TC1 to TC3) shown in the test case ID 111A of the test list 111. The test result 116C records the result of the real machine test in each test case, and "Pass" or "Fail" is recorded.

Specifically, for instance, in the case of the real machine test result table 116 illustrated in Fig. 6, the real machine testing unit 102 executed the test case having the test case ID of "TC2" in the hardware to be tested 30 as the first test (test sequence number "1"), and the result was "Fail".

### (1-3) Various types of processing

The processing to be executed by the respective functional configurations (test selection unit 101, real machine testing unit 102, screen display operation unit 103) in the hardware testing device 10 according to this embodiment is now explained in detail.

Fig. 8 is a flowchart showing an example of the processing routine of the test selection processing. While the test selection processing is mainly performed by the test selection unit 101, a part of the processing (steps S104, S106, S107) is controlled by the screen display operation unit 103.

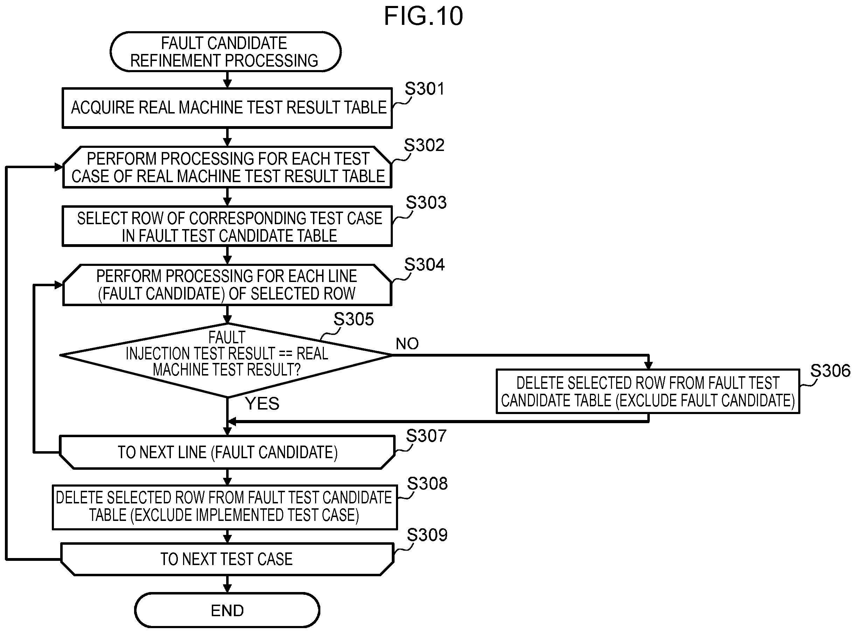

Foremost, in step S101, the test selection unit 101 copies the fault injection test result table 113 and thereby creates the fault test candidate table 114. At this point, while all primary faults registered in the fault list 112 are indicated as fault candidates in the fault test candidate table 114, the fault candidates of the primary faults can be refined based on the results of the real machine tests up to such point in time. Thus, in step S102, by referring to the real machine test result table 116 and performing the fault candidate refinement processing, the faults (primary faults) in which the possibility of occurrence can be eliminated among the fault candidates indicated in the fault test candidate table 114 are deleted. Details of the fault candidate refinement processing will be described later with reference to Fig. 10.

In step S103, the test selection unit 101 determines whether the number of fault candidates indicated in the fault test candidate table 114 is one fault candidate or no fault as a result of performing the fault candidate refinement processing of step S102.

When a positive result is obtained in step S103 (step S103: YES), the screen display operation unit 103 displays, on the display terminal (display), information related to the fault candidate (or no fault) indicated in the fault test candidate table 114 (step S104), and then ends the test selection processing. Note that, in this embodiment, by assigning the primary fault ID of "no fault" even when there is no remaining fault candidate in the fault test candidate table 114, this is handled as one type of fault for the sake of convenience. As a result of adopting the foregoing configuration, it is possible to display, on the display terminal (display), information related to the result of "no fault" even in cases where there was no fault in step S104.

Meanwhile, when a negative result is obtained in step S103; that is, when two or more fault candidates are remaining (step S103: NO), the test selection unit 101 performs the test priority table creation processing in order to prioritize the test cases that have not yet been executed, and then creates the test priority table 115 (step S105). Details of the test priority table creation processing will be described later with reference to Fig. 11.

Subsequently, the screen display operation unit 103 displays, on the display terminal (display), information related to the fault candidates indicated in the fault test candidate table 114 at such point in time (step S106). The screen to be displayed on the screen display operation unit 103 will be explained later with reference to Fig. 15 while explaining specific processing examples. Furthermore, the screen display operation unit 103 also displays information related to the test priority table 115 on the display terminal, and selects the test case with the highest priority (step S107). Note that the selection of the test case with the highest priority may be based on the user's selection operation performed to the input device 15, or the test selection unit 101 may automatically select the test case with the highest priority. For example, when the test cases are to be continuously executed in the hardware test, the test selection unit 101 may select the test case with the highest priority (priority level) among the test candidates indicated in the test priority table 115.

Subsequently, the real machine testing unit 102 commences the real machine test processing for executing the test case selected in step S107 in the hardware to be tested 30. While details of the real machine test processing will be explained later with reference to Fig. 9, the routine returns to step S101 of Fig. 8 after the real machine test processing is completed, and the next test selection processing is performed.

Fig. 9 is a flowchart showing an example of the processing routine of the real machine test processing. The real machine test processing is executed by the real machine testing unit 102.

In the real machine test processing, foremost, the real machine testing unit 102 executes, in the hardware to be tested 30, the highest priority test case selected in the test selection processing (refer to step S107 of Fig. 8) (step S201). Here, the method of executing the test case shall be pursuant to the test procedure 111B corresponding to the test case of the test list 111. The test case may be executed automatically by software, or executed manually by the user.

After the real machine test of the test case is completed, the real machine testing unit 102 determines whether the test result is "Pass" or "Fail" based on the pass/fail criterion 111C (refer to Fig. 3) corresponding to the test case of the test list 111, and stores the test result in the real machine test result table 116 (step S202). The specific configuration of the real machine test result table 116 is as illustrated in Fig. 7, and also includes a test sequence number 116A (order of the real machine test of the test case) and a test case ID 116B (test case ID of the test case) in addition to the test result 116C.

When the real machine test of the test case is manually executed in step S201 and the confirmation is also consequently performed manually, the user operates the input device 15 and inputs the real machine test result, and, as a result of the input content being transmitted to the real machine testing unit 102 via the screen display operation unit 103, the test result is stored in the real machine test result table 116.

Because the real machine test based on the highest priority test case will be complete as a result of the processing of steps S201 to S202 being performed, the test selection processing (Fig. 8) is performed once again in order to select the test case to be subsequently executed. In the test selection processing, the test case with the lowest secondary fault rate among the remaining test cases that have not yet been executed is selected as the next test case, and the real machine test of the selected test case is performed in the real machine test processing. This kind of loop processing of the test selection processing (Fig. 8) and the real machine test processing (Fig. 9) is repeated until the number of fault candidates indicated in the fault test candidate table 114 based on the fault candidate refinement processing (step S102) of the test selection processing becomes one fault candidate or no fault (step S103: YES). According to the hardware testing device 10 of this embodiment, because a plurality of test cases are executed in order from the test case having the lowest secondary fault occurrence rate (secondary fault rate) based on the foregoing loop processing and the results thereof are accumulated, it is possible to execute the real machine test of a series of test cases while minimizing the secondary fault rate.

The fault candidate refinement processing that is performed during the test selection processing is now explained in detail. Fig. 10 is a flowchart showing an example of the processing routine of the fault candidate refinement processing. The fault candidate refinement processing corresponds to the processing shown in step S102 of Fig. 8, and is executed by the test selection unit 101.

According to Fig. 10, foremost, the test selection unit 101 refers to the real machine test result table 116 (step S301), selects one test case among the test cases recorded in the real machine test result table 116 which has not yet been selected, and executes the processing of steps S303 to S308 (step S302). Note that the processing of steps S303 to S308 is repeatedly performed until all test cases recorded in the real machine test result table 116 have been selected.

In step S303, the test selection unit 101 selects the column of the test case corresponding to the test case selected in step S302 among the fault candidates indicated in the fault test candidate table 114. As previously explained with reference to Fig. 8, because the fault test candidate table 114 that was initially created is a copy of the fault injection test result table 113, it has the same configuration as the fault injection test result table 113; specifically, it includes the combination of the test result for each primary fault, and the secondary fault, for each test case (refer to Fig. 5).

Next, the test selection unit 101 selects one primary fault (fault candidate), which has not yet been selected, indicated in each line of the column (test case) selected in step S303, and performs the processing of steps S305 to S306 (step S304). Note that the processing of steps S305 to S306 is repeatedly performed until all primary faults (fault candidates) indicated in each line of the column (test case) selected in step S303 have been selected.

In step S305, the test selection unit 101 determines whether or not the test result of the fault injection test and the test result of the real machine test coincide regarding the test result in the primary fault (fault candidate) selected in step S304. The test result of the fault injection test can be confirmed by referring to the test result 113C of the fault injection test result table 113 copied to the fault test candidate table 114 (refer to Fig. 5). Moreover, the test result of the real machine test can be confirmed by referring to the test result 116C of the real machine test result table 116 (refer to Fig. 7).

When the test result of the fault injection test coincides with the test result of the real machine test in the comparative determination in step S305 (step S305: YES), the routine proceeds to the processing of step S307 without performing any special processing. When the test result of the fault injection test does not coincide with the test result of the real machine test in the comparative determination in step S305 (step S305: NO), because this means that the selected primary fault (fault candidate) is a fault candidate that does not coincide with previous real machine test results, this fault candidate is excluded from the fault test candidate table 114 (step S306). Specifically, the line corresponding to the primary fault (fault candidate) selected in step S304 is deleted from the fault test candidate table 114.

Subsequently, in step S307, the routine returns to the processing of step S304 for performing the comparative determination of the next line (fault candidate). After the routine returns to step S304, another line (fault candidate), which has not yet been selected, is selected among the primary faults (fault candidates) indicated in each line of the column (test case) selected in step S303 (step S304), and the routine proceeds to the comparative determination of step S305.

When the foregoing processing regarding the primary faults (fault candidates) of each line in the column (test case) selected in step S303 is completed, the test selection unit 101 deletes the selected column from the fault test candidate table 114 (step S308). Based on the processing of step S308, the test cases that have undergone the real machine test are excluded from the fault test candidate table 114.

Subsequently, the test selection unit 101 returns to the processing of step S302 in order to perform similar processing regarding the remaining test cases, which have not yet been selected, among the test cases recorded in the real machine test result table 116 (step S309). After returning to step S302, another test case, which has not yet been selected, among the test cases recorded in the real machine test result table 116 is selected, and the processing of step S303 onward is performed. When the processing of steps S303 to S308 is ultimately completed regarding all test cases recorded in the real machine test result table 116, the fault candidate refinement processing is ended.

Because the fault candidates of the primary faults that do not coincide with the previous real machine test results and previously executed test cases are deleted from the fault test candidate table 114, which was created by copying the fault injection test result table 113, by performing the processing of steps S301 to S309 of Fig. 10, it is possible to refine the test objects in the fault test candidate table 114 to possible fault candidates and unexecuted test cases at such point in time. Based on this process of refining the test objects, the hardware testing device 10 can suppress the execution of unneeded repetitive processing, and thereby reduce the processing load in the various devices and improve the testing speed of the overall hardware test.

The test priority table creation processing that is performed during the test selection processing is now explained in detail. Fig. 11 is a flowchart showing an example of the processing routine of the test priority table creation processing. The test priority table creation processing corresponds to the processing shown in step S105 of Fig. 8, and is executed by the test selection unit 101.

According to Fig. 11, the test selection unit 101 foremost initializes the secondary fault rate 115B and the priority 115C in each column (test candidate 115A) of the test priority table 115 to zero (step S401). Next, the test selection unit 101 refers to the fault test candidate table 114, and repeats the processing of steps S403 to step S406 for each column (test case) recorded in the fault test candidate table 114 (step S402).

Here, because the fault candidate refinement processing (step S102 of Fig. 8, Fig. 10) has already been completed at the time that the test priority table creation processing is performed, the lines of the fault candidates of the primary faults that do not coincide with the previous real machine test results and the columns of previously executed test cases are deleted from the fault test candidate table 114 based on the entries of the real machine test result table 116. Accordingly, in the processing of step S402 onward, unexecuted test cases are selected one by one.

Note that, while the test case selected in step S402 is recorded in the test candidate 115A of the test priority table 115, at this point in time, the secondary fault rate 115B and the priority 115C of the recorded test case are the initial value of zero.

In step S403, one primary fault (fault candidate) among the primary faults (fault candidates) in each line of the fault test candidate table 114; that is, those remaining after the fault candidate refinement processing has been performed, in the column (test case) is selected in step S402.

Subsequently, in step S404, the test selection unit 101 refers to the fault test candidate table 114, and confirms whether or not the secondary fault corresponding to the primary fault (fault candidate) selected in step S403 is "No". When the secondary fault is "No" (step S404: YES), the routine proceeds to the processing of the next line (fault candidate) without performing any special processing (step S406). Meanwhile, when the secondary fault is "Yes" (step S404: NO), the test selection unit 101 acquires the primary fault rate of the selected fault candidate from the primary fault rate 112B of the fault list 112, adds the acquired primary fault rate to the secondary fault rate 115B of the test priority table 115 (step S405), and thereafter proceeds to step S406.

After the processing of steps S403 to S406 is performed for all lines (all fault candidates) of the fault test candidate table 114, the test selection unit 101 ends this loop processing, and then performs similar processing regarding the next column (test case) recorded in the fault test candidate table 114 (step S407). When the processing of steps S402 to S407 is performed for all columns (all test cases) recorded in the fault test candidate table 114, the calculation of the secondary fault rate regarding all test cases (entry in the secondary fault rate 115B of the test priority table 115) is ended.

Note that, in this example, while each fault candidate is hypothesized as being an independent cause in order to simplify the explanation, upon calculating the sum of the fault rates regarding a plurality of fault candidates, because generally a common cause exists among the faults, there is a possibility that a simple addition will result in over-evaluation. In the foregoing case, a strict fault rate can be calculated by using the information of the generally known Fault Tree Analysis.

When the calculation of the secondary fault rate regarding all test cases recorded in the fault test candidate table 114 is completed, the test selection unit 101 performs the test priority determination processing for prioritizing the respective test cases (step S408), and then ends the test priority table creation processing.

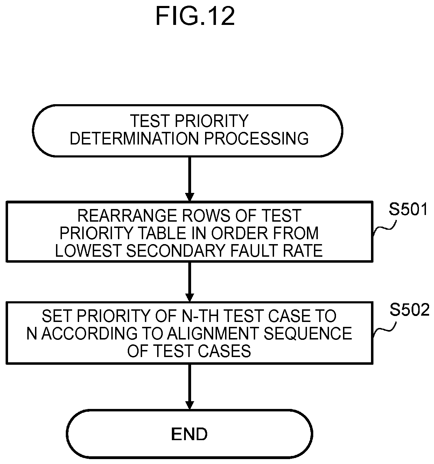

Fig. 12 is a flowchart showing an example of the processing routine of the test priority determination processing. The test priority determination processing corresponds to the processing shown in step S408 of Fig. 11, and is executed by the test selection unit 101.

According to Fig. 12, the test selection unit 101 determines the priority based on the secondary fault rate 115B (refer to step S405 of Fig. 11) calculated for each test case regarding the respective test cases (test candidate 115A) recorded in the test priority table 115. Specifically, for instance, each column (test candidate 115A) of the test priority table 115 is rearranged in order from the lowest secondary fault rate, and the test case with the lowest secondary fault rate is moved to the left side (step S501). If a plurality of test cases have the same secondary fault rate, the test cases are arranged in order from the smallest test case ID described in the test candidate 115A (corresponds to the test case ID 111A of the test list 111). Specifically, for instance, when TC1 to TC3 have the same secondary fault rate, they are arranged in the order of TC1, TC2, TC3 from left to right.

Subsequently, the test selection unit 101 sets the priority 115C to "N" regarding the test candidate (test case) of the N-th column (N: integer) from the left of the test priority table 115 rearranged in step S501, and records the setting (step S502). The processing of step S502 is performed for all test candidates recorded in the test priority table 115, and, consequently, the priority of 1" to "N" will be assigned to all test candidates (test cases).

Accordingly, by performing the test priority table creation processing illustrated in Fig. 11 (including the test priority determination processing that was described in detail with reference to Fig. 12), the test selection unit 101 can create/update the test priority table 115 in which the unexecuted test cases have been prioritized in order from the unexecuted test case having the lowest secondary fault rate.

### (1-4) Specific processing example

In (1-3) above, the processing routine of the processing to be executed by the respective functional configurations of the hardware testing device 10 according to this embodiment was explained, but in the ensuing explanation, the flow of the overall processing will be explained by listing specific processing examples.

Here, let it be assumed that, prior to the real machine test to be conducted to the hardware to be tested 30 by the hardware testing device 10, as the prerequisite processing, the simulation test is performed in advance by the simulation testing unit 201 based on the test list 111 illustrated in Fig. 3 and the fault list 112 illustrated in Fig. 4, and the fault injection test result table 113 illustrated in Fig. 5 has been created and stored in the hardware testing device 10.

Under these circumstances, the test selection processing to be performed by the test selection unit 101 is started. Because not one real machine test has been executed to the hardware to be tested 30 by the real machine testing unit 102 in the beginning, the test case to be executed first is determined based on the fault injection test result table 113, and the real machine test is performed in the hardware to be tested 30. The processing up to this point is hereinafter referred to as the "first round test".

Subsequently, the fault candidates are refined based on the execution result of the test case executed in the first round test (real machine test result table 116), and then the test case to be executed next is determined, and the real machine test is performed in the hardware to be tested 30. The processing up to this point is hereinafter referred to as the "second round test".

Foremost, in the first round test, the test selection unit 101 acquires the fault injection test result table 113 and creates the fault test candidate table 114 according to the flowchart illustrated in Fig. 8 (step S101), and thereafter proceeds to the fault candidate refinement processing of step S102. However, because there is no result of the real machine test in the first round test, even if the fault candidate refinement processing is performed according to the flowchart illustrated in Fig. 10, the fault test candidate table 114 will remain unchanged in the same state of being copied from the fault injection test result table 113 in step S101 (no refinement has been performed).

Next, the test selection unit 101 determines whether the number of fault candidates is one fault candidate or no fault in step S103. Here, because the fault test candidate table 114 is still in the same state of being copied from the fault injection test result table 113, the four primary faults of "fault F1" to "fault F4" remain as the fault candidates (refer to Fig. 5), and the routine proceeds to the test priority table creation processing of step S105.

The test priority table creation processing is performed according to the flowcharts illustrated in Fig. 11 and Fig. 12. Specifically, after the initialization of the test priority table 115 (step S401), the secondary fault rate is calculated regarding the respective test cases (fault F1 to fault F4) of the fault test candidate table 114 (step S402 to S407). Here, according to the fault test candidate table 114 (same as the fault injection test result table 113 because it is the first round test), because the three test cases of "TC1" to "TC3" are recorded, the secondary fault rate is calculated for each of these test cases.

Each test case is now reviewed in terms of the secondary fault rate. For the test case "TC1", upon referring to Fig. 5, because the secondary fault is "Yes" only when the primary fault is "fault F1", the secondary fault rate in "TC1" is "0.01" as the primary fault rate of "fault F1". The primary fault rate of "fault F1" can be acquired from the primary fault rate 112B of the fault list 112 illustrated in Fig. 4.

For the test case "TC2", upon referring to Fig. 5, because the secondary fault is "No" in all primary faults, the secondary fault rate in "TC2" will be "0".

For the test case "TC3", upon referring to Fig. 5, because the secondary fault is "Yes" in each of the cases where the primary fault is "fault F2" to "fault F4", "0.09" as the sum of the respective secondary fault rates will become the secondary fault rate in "TC3". Specifically, according to the primary fault rate 112B of the fault list 112 illustrated in Fig. 4, because the primary fault rate of "fault F2" is "0.02", the primary fault rate of "fault F3" is "0.03", and the primary fault rate of "fault F4" is "0.04", the sum of these primary fault rates will be "0.09".

The secondary fault rate of the respective test cases "TC1" to "TC3" is calculated by performing the processing of steps S402 to S407 of Fig. 11 as described above. Subsequently, the test priority determination processing is performed in step S408.

The test priority determination processing is performed according to the flowchart illustrated in Fig. 12, and the priority of the test cases is determined based on the size of the secondary fault rate. As described above, because the secondary fault rates of the test cases "TC1", "TC2", "TC3" were in the order of "0.01", "0", "0.09", when the priority is assigned in order from the lowest secondary fault rate (step S501, S502), the priority of "TC2" is "1", the priority of "TC1" is "2", and the priority of "TC3" is "3". The entries at such point in time are illustrated in Fig. 6.

As a result of the test priority determination processing ending, the test priority table creation processing of step S105 is ended in the test selection processing illustrated in Fig. 7.

Subsequently, in step S106, the screen display operation unit 103 displays, on the display terminal (display), information related to the fault candidates indicated in the fault test candidate table 114 at such point in time. Specifically, because "fault F1" to "fault F4" are indicated as the fault candidates in the fault test candidate table 114, the names and fault description (can be acquired from the fault description 112C of Fig. 4) of these primary faults are displayed. Moreover, in step S107, the screen display operation unit 103 displays, on the display terminal, information related to the test priority table 115, and the test case with the highest priority is selected. Specifically, the respective test cases are displayed in the order of "TC2", "TC1", "TC3" according to the priority, and the secondary fault rate in each test case is displayed. When this kind of screen is displayed, "TC2" is selected as the highest priority test case by the program or the user.

Upon receiving the result of this kind of test selection processing, the real machine testing unit 102 performs the real machine test processing according to the flowchart illustrated in Fig. 9. In step S201, the real machine testing unit 102 executes, in the hardware to be tested 30, the real machine test based on the test case "TC2" selected in the test selection processing. Subsequently, the real machine testing unit 102 stores the test result in the real machine test result table 116 (step S202). Fig. 7 illustrates the real machine test result table 116 in the foregoing case. According to Fig. 7, the test sequence number 116A stores "1" indicating the first round test, the test case ID 116B stores "TC2" corresponding to the executed test case, and the test result 116C stores the test result of "Fail". The processing of the first round test is thereby completed.

The processing of the second round test is now explained. In the second round test, the test selection unit 101 acquires the fault injection test result table 113 and creates the fault test candidate table 114 in the same manner as the first round test (step S101 of Fig. 8), and then proceeds to the fault candidate refinement processing (step S102).

In the fault candidate refinement processing of the second round test, because the test result of the real machine test executed by the real machine testing unit 102 in the first round test (that is, the test result of the test case TC2 was "Fail") is recorded in the real machine test result table 116, this test result is used to refine the fault candidates.

When the processing is advanced according to the flowchart of Fig. 10, in the fault candidate refinement processing of the second round test, the primary faults in which the test result in the test case "TC2" is "Pass" can be excluded from the fault candidates among the entries of the fault test candidate table 114 in the processing of steps S304 to S307 with the execution result of "TC2 recorded in the real machine test result table 116 being "Fail" as the hint. Specifically, upon referring to the fault injection test result table 113 of Fig. 5, because there are "no fault", "fault F1", and "fault F2" as the primary faults in which the test result of the test case "TC2" is "Pass", the lines of these primary faults are deleted from the fault test candidate table 114, and the lines of "fault F3" and "fault F4" will remain. Furthermore, because the test case "TC2" has already been executed, the column of "TC2" is also deleted from the fault test candidate table 114 in the processing of step S308.

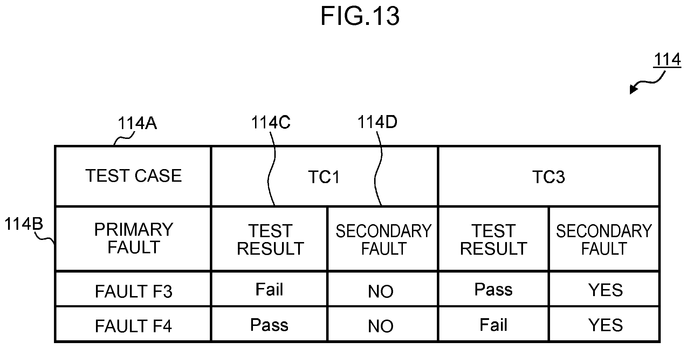

Here, Fig. 13 is a diagram explaining an example of the fault test candidate table. The fault test candidate table 114 illustrated in Fig. 13 shows the entries after the fault candidate refinement processing is performed in the second round test as described above. Upon referring to Fig. 13, while the table configuration of the fault test candidate table 114 is the same as the table configuration (Fig. 5) of the fault injection test result table 113, upon reviewing the test case 114A, only "TC1" and "TC3" are indicated after the previously executed "TC2" has been excluded. Moreover, "no fault", "fault F1", and "fault F2" are also excluded regarding the primary fault 114B, and only "fault F3" and "fault F4" are indicated. Furthermore, in correspondence with these primary faults, the result (test result 114C) of the simulation test and the existence of a secondary fault (secondary fault 114D) are indicated.

After the fault candidate refinement processing of step S102 is performed, while the number of remaining fault candidates is determined in step S103 in the same manner as the first round test, because there are the two fault candidates of "TC1" and "TC3" as illustrated in Fig. 13, the test priority table creation processing of step S105 is performed.

The test priority table creation processing is performed according to the flowcharts illustrated in Fig. 11 and Fig. 12, and the secondary fault rate and the priority are calculated regarding the respective test cases of "TC1" and "TC3". Specifically, upon referring to the fault test candidate table 114 illustrated in Fig. 13, for the test case "TC1", because the secondary fault is "No" in all primary faults ("fault F3", "fault F4"), the secondary fault rate of "TC1" is "0". Meanwhile, for the test case "TC3", because the secondary fault is "Yes" in both "fault F3" and "fault F4" and the respective primary fault rates are "0.03" and "0.04" (refer to the primary fault rate 112B of Fig. 4), the secondary fault rate of "TC3" becomes "0.07" as the sum of the foregoing primary fault rates.

Fig. 14 is a diagram explaining an example of the test priority table in a second round test. The test priority table 115 illustrated in Fig. 14 shows the entries after the test priority table creation processing has been performed in the second round test as described above. Upon comparing the test priority table 115 of Fig. 14 with the test priority table 115 of Fig. 6 illustrating the entries of the first round test, while the table configurations are the same, the previously executed test case "TC2" is not indicated. Moreover, even with regard to the secondary fault rate of the respective test cases, because "no fault", "fault F1", and "fault F2" have been excluded in the fault candidate refinement processing of the second round test, fault rates that are different from the first round test are indicated. In summary, in the test priority table 115 of the second round test, the secondary fault rate of the test case "TC1" is "0" and the priority is "1", and the secondary fault rate of the test case "TC3" is "0.07" and the priority is "2".

As a result of the test priority determination processing ending as described above, the test priority table creation processing of step S105 is ended in the test selection processing illustrated in Fig. 7.

Subsequently, in step S106, the screen display operation unit 103 displays, on the display terminal (display), information related to the fault candidates indicated in the fault test candidate table (fault test candidate table 114 of Fig. 13) at such point in time. Specifically, the fault candidates remaining in the fault test candidate table 114 after the fault candidate refinement processing are "fault F3" and "fault F4". The names and fault description (can be acquired from the fault description 112C of Fig. 4) of these primary faults are displayed. Moreover, in step S107, the screen display operation unit 103 displays, on the display terminal, information related to the test priority table (test priority table 115 of Fig. 14), and the test case with the highest priority is selected. Specifically, the respective test cases are displayed in the order of "TC1", "TC3" according to the priority, and the secondary fault rate in each test case is displayed. When this kind of screen is displayed, "TC1" is selected as the highest priority test case in which the real machine test is to be subsequently performed. Subsequently, when "TC1" is selected in step S107, the real machine testing unit 102 executes the real machine test based on the test case "TC2" in the hardware to be tested 30, and the test result is stored in the real machine test result table 116. When the processing up to this point is ended, the processing of the second round test is completed.

Here, a specific example of the screen to be displayed by the screen display operation unit 103 is shown. Fig. 15 is a diagram explaining an example of the display screen of an output device. The display screen 160 of Fig. 15 shows an example of the display output on the display (output device 16) controlled by the screen display operation unit 103, and illustrates a screen display example at the timing (however, the highest priority test case to be subsequently executed has not been selected) that the test priority table is displayed after the completion of the test priority table creation processing in the second round test among the foregoing specific processing examples.

According to Fig. 15, the display screen 160 is configured by comprising a real machine test result input area 161, a real machine test result registration button 162, a fault candidate display area 163, and a test priority display area 164.

The real machine test result input area 161 is an area for inputting (or displaying) the test result of the real machine test that was performed to the hardware to be tested 30 by the real machine testing unit 102. For example, Fig. 15 shows the test result of the real machine test regarding the "highest priority test case "TC2"" which was selected based on the processing result of the test selection processing of the first round test. When the test result of the real machine test is input by the user, the test case "TC2" in which the real machine test was performed and the test result of "Fail" are input in the real machine test result input area 161.

Furthermore, the real machine test result registration button 162 is a button that is pressed for registering/storing, in the real machine test result table 116, the test result of the real machine test input in the real machine test result input area 161. This button becomes effective when the user inputs the test result of the real machine test in the real machine test result input area 161, and the input test result is additionally registered in the real machine test result table 116 when this button is pressed. Note that, in the hardware testing device 10, when the test result of the real machine test is registered, let it be assumed that the test selection unit 101 automatically performs the test candidate selection processing based on the real machine test result table 116 after the registration.

Moreover, as previously explained, with the hardware testing device 10 according to this embodiment, the real machine test can also be automatically executed using software, and, in the foregoing case, the user's input to the real machine test result input area 161 and pressing operation of the real machine test result registration button 162 are not required. Thus, when the real machine test is automatically executed based on software, the real machine test result input area 161 may also be an area for displaying the result of the automatically executed real machine test. Here, the result of the real machine test is recorded in the real machine test result table 116, and the recorded entries are thereafter displayed on the real machine test result input area 161. Moreover, the real machine test result registration button 162 may also be used as a button for starting the execution of the real machine test of the highest priority test case to be subsequently executed when the real machine test is automatically executed based on software.

Next, the fault candidate display area 163 is an area for displaying information corresponding to the processing of step S106 (or step S104) of Fig. 8; that is, an area for displaying information related to the fault candidates indicated in the fault test candidate table 114 at such point in time. For example, in the case of Fig. 15, let it be assumed that the test result of the real machine test of the test case "TC2" was input (or displayed) in the real machine test result input area 161 and the real machine test result registration button 162 has been pressed. This status, in terms of the foregoing specific processing example, corresponds to the state of the second round test after obtaining the result of the real machine test of the test case "TC2" that was executed in light of the processing result of the first round test.

A specific example of the fault test candidate table 114 in the second round test is shown in Fig. 13, and, according to this example, the fault candidate of the primary fault is "fault F3" or "fault F4". Furthermore, according to the fault description 112C (Fig. 4) of the fault list 112, the fault description of "fault F3" is "circuit A short circuit", and the fault description of "fault F4" is "component B damaged". The fault candidate display area 163 of Fig. 15 displays information related to these fault candidates.

The test priority display area 164 is an area for displaying information corresponding to the processing of step S107 of Fig. 8; that is, an area for displaying information related to the test priority table 115. For example, in the case of Fig. 15, because it is the state of the second round test, information of the test priority table 115 illustrated in Fig. 14 is displayed. As a result of displaying this kind of information, not only can the user recognize the highest priority test case among the unexecuted test cases in which the real machine test is to be subsequently executed and the secondary fault rate thereof, the user can also comprehend the priority and secondary fault rate of the remaining test cases at such point in time.

Note that, while the display screen of Fig. 15 illustrates one state of the second round test, when the test is repeated until the number of fault candidates indicated in the fault test candidate table 114 becomes one fault candidate or less, as explained in step S104 of Fig. 8, the last remaining fault candidate or "no fault" is displayed in the fault candidate display area 163. Here, the real machine test of the hardware to be tested 30 regarding all test cases is completed, and the ultimate fault candidates are displayed.

Moreover, the display screen example of Fig. 15 is merely an example of the display output by the hardware testing device 10 according to this embodiment, and the display screen may also be configured comprising display areas and display contents that are different from Fig. 15. The display timing in each display area is also not limited the example illustrated in Fig. 15, and information is preferably displayed in a display mode so that the user can easily understand the test status.

Specific processing examples in the first round test and the second round test were explained above, but the foregoing processing is also repeated from the second round test onward until the number of fault candidates indicated in the fault test candidate table 114 becomes one fault candidate or less. In other words, in each round test, the test selection unit 101 calls the test case with the lowest secondary fault rate, and the real machine testing unit 102 performs the real machine test based on that test case and then obtains the test result ("Pass", "Fail") thereof. Then, in the subsequent round test, the processing of excluding the fault candidates which do not match the test result based on the obtained test result of the real machine test, and once again calculating the secondary fault rate for each fault candidate and selecting the next test case, is repeated.

### (1-5) Summary

As explained above, the hardware testing device 10 according to the first embodiment calculates the secondary fault rate of each test case in the actual test from the fault rate of the primary fault based on data storing the test case execution result and the existence of a secondary fault in a state in which a primary fault has been injected in the advance simulation test, and thereby prioritizes the test cases. Moreover, each time a test case is executed and a result is obtained, the fault candidates are refined based on the advance fault injection test result, and the secondary fault rate of the unexecuted test cases is updated. Accordingly, by dynamically calculating the secondary fault rate and selecting the highest priority test case, the secondary fault rate up to the completion of all test cases can be minimized. This kind of hardware testing device 10 can be applied to a system which performs fault analysis to the test objects.

In particular, the hardware testing device 10 according to this embodiment is characterized in performing the fault candidate refinement processing based on the latest real machine test result each time that the real machine test result of the test case is updated, and excluding the fault candidates of the primary faults that do not coincide with the previous real machine test results and previously executed test cases in the foregoing processing. Subsequently, by recalculating the secondary fault rate of the unexecuted test cases based on the latest information after the foregoing exclusion, it is possible to calculate relative secondary fault rates of higher precision. Thus, the selection of test cases capable of minimizing the possibility of the occurrence of a secondary fault is enabled, and the effect of suppressing the time, cost and labor required for the tests throughout the entire hardware test can be expected.

Note that the "secondary fault rate" used for determining the priority of the test cases in the first embodiment is merely one example of the parameters related to the secondary fault, and, in the second embodiment described later, the "recovery cost expected value of the secondary fault" is used as another example.

### (2) Second embodiment

The hardware testing device according to the second embodiment of the present invention is now explained.

The first embodiment described above explained a method of determining the priority of the test case to be subsequently executed based on the probability of the secondary fault (secondary fault rate) that may occur when the test case is executed. Nevertheless, when examining the priority which gives consideration to the occurrence of a secondary fault, there may be cases where the user wishes to determine the priority based on the level of seriousness associated with the secondary fault.

For example, when a certain secondary fault occurs, while it may be possible to repair/recover from the fault with a simple measure on the one hand, if another secondary fault occurs, huge costs may be required for the repair/recovery due to the damage of the overall hardware to be tested 30 on the other. In the foregoing case, even if the secondary fault rate is of the same probability, a scheme for giving preference to the former secondary fault, in which the repair/recovery is easy, will be required.

From the foregoing perspective, the second embodiment will explain a hardware testing device and a hardware testing method which calculate the priority of the test cases by giving consideration to the secondary fault recovery cost.

In comparison to the hardware testing method based on the hardware testing device 10 explained in the first embodiment, the second embodiment differs only with respect to the point that the test cases are prioritized by giving consideration not only to the probability of the secondary fault (secondary fault rate), but by also giving consideration to the recovery cost at the time of occurrence of the secondary fault. Thus, the second embodiment will be explained by applying the hardware testing device 10 explained in the first embodiment.

In the second embodiment, because consideration is given to the recovery cost when a secondary fault occurs upon prioritizing the test cases in the hardware testing device 10, it is necessary to give consideration to the recovery cost upon the occurrence of a secondary fault at the stage of the simulation test that is performed as the pre-processing by the simulation testing device 20. Thus, specifically, the recovery cost upon the occurrence of a secondary fault is additionally indicated in the fault injection test result table storing the test results of the simulation tests conducted by the simulation testing unit 201.

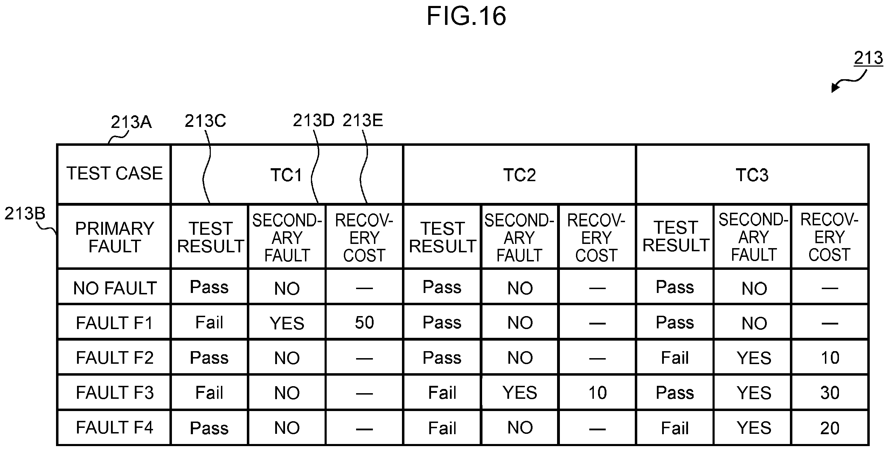

Fig. 16 is a diagram explaining an example of the fault injection test result table used in the second embodiment. The fault injection test result table 213 illustrated in Fig. 16 stores the test results of the simulation tests conducted by the simulation testing unit 201 in the hardware simulation device 202 based on the test list 111 and the fault list 112 as with the fault injection test result table 113 (refer to Fig. 5) in the first embodiment.

Upon reviewing the table configuration of the fault injection test result table 213 illustrated in Fig. 16, a recovery cost 213E is indicated in addition to the same configuration (specifically, test case 213A, primary fault 213B, test result 213C, and secondary fault 213D) as the fault injection test result table 113 illustrated in Fig. 5 in the first embodiment.

The recovery cost 213E indicates the costs required for the recovery in the occurrence of the corresponding secondary fault. Specifically, for example, in Fig. 16, when the simulation test based on the test case "TC1" under the status of the primary fault "fault F1" is conducted, the secondary fault is indicated as "Yes" and the recovery cost in such a case is indicated as "50". Moreover, for example, secondary faults have respectively occurred in the test case "TC3" under the statuses of the primary faults "fault F2", "fault F3", "fault F4", and the respective recovery costs are indicated as "10", "30", "20".

Here, as the numerical value and unit of the recovery cost 213E, for instance, the price and delivery date of the fault component or the man-month required for the recovery may be considered, but the method of indication may be arbitrary to the extent that the differences in the recovery costs can be relatively expressed for each state in a unified manner in the table. Specifically, in terms of the test case "TC3" described above, the secondary fault recovery cost is the highest when the primary fault is "fault F3", and followed by the case when the primary fault is "fault F4", and the case when the primary fault is "fault F2" has the lowest recovery cost among the secondary faults that may occur.

In the ensuing explanation, the processing performed by the hardware testing device 10 of the second embodiment in cases where the foregoing fault injection test result table 213 is stored based on the pre-processing is explained.

In the second embodiment, the flow of the overall processing of the test selection unit 101 performing the test selection processing and selecting the highest priority test case, the real machine testing unit 102 conducting the real machine test based on the highest priority test case, and the subsequent test selection processing being additionally performed based on the test result of that real machine test is the same as the first embodiment. Nevertheless, processing that differs from the first embodiment is performed in the part related to the determination of priority.

More specifically, the overview of the test selection processing (Fig. 8), the fault candidate refinement processing (Fig. 10), and the real machine test processing (Fig. 9) are basically the same as the processing in the first embodiment. Meanwhile, the test priority table creation processing (Fig. 11), and the test priority determination processing (Fig. 12) are different from the processing in the first embodiment.

Note that, of the test selection processing illustrated in Fig. 8, in step S101, while the test selection unit 101 copies the fault injection test result table and creates the fault test candidate table, the fault injection test result table 213 illustrated in Fig. 16 is used in the second embodiment. The table configuration of the fault injection test result table 213 differs from the fault injection test result table 113 shown in the first embodiment with respect to the point that the recovery cost 213E is included as described above, and, therefore, the copy destination fault test candidate table (not shown) also has the same table configuration.

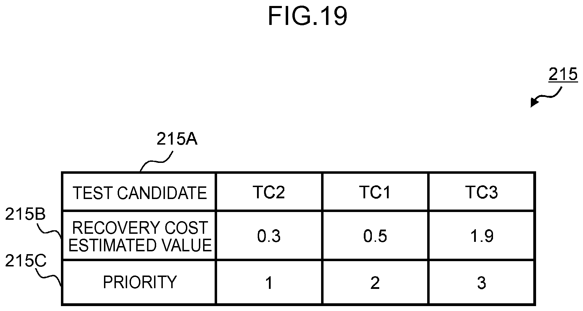

Moreover, also with regard to the test priority table storing information indicating the priority of the unexecuted test cases to be subject to the real machine test, because priority is assigned by giving consideration to the secondary fault recovery cost in the second embodiment, the table configuration differs from the test priority table (for example, Fig. 6 and Fig. 14) shown in first embodiment. A specific table configuration is as illustrated in Fig. 19, and the test priority table 215 includes a recovery cost expected value 215B and a priority 215C regarding the test cases (test candidate 215A) which have not yet undergone the real machine test at such point in time.

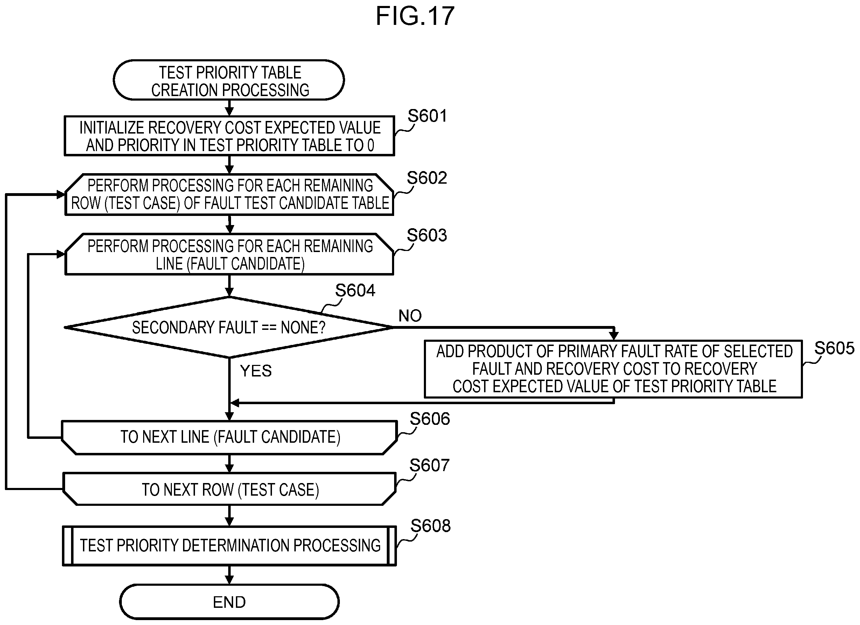

Fig. 17 is a flowchart showing an example of the processing routine of the test priority table creation processing in the second embodiment. As shown in Fig. 17, the test selection unit 101 initializes the recovery cost expected value 215B and the priority 215C in each column (test candidate 215A) of the test priority table 215 to zero (step S601).

Next, the test selection unit 101 refers to the fault test candidate table and repeats the processing of step S603 to step S606 for each column (test case) stored in the fault test candidate table (step S602).

In step S603, one primary fault (fault candidate) among the primary faults (fault candidates) in each line of the fault test candidate table; that is, those remaining after the refinement based on the fault candidate refinement processing was performed, is selected in the column (test case) selected in step S602.

In step S604, the test selection unit 101 refers to the fault test candidate table, and confirms whether or not the secondary fault corresponding to the primary fault (fault candidate) selected in step S603 is "No". When the secondary fault is "No" (step S604: YES), the routine proceeds to the processing of the next line without performing any special processing (step S606). Meanwhile, when the secondary fault is "Yes" (step S604: NO), the test selection unit 101 adds, to the recovery cost expected value 215B of the test priority table 215, the product of the primary fault rate of the selected fault candidate and the recovery cost upon occurrence of a secondary fault (step S605). Note that the primary fault rate of the fault candidate can be acquired from the primary fault rate 112B of the fault list 112, and the recovery cost upon occurrence of a secondary fault can be acquired from "recovery cost" of the fault test candidate table obtained by copying the fault injection test result table 213. When the processing of step S605 is completed, the test selection unit 101 proceeds to the processing of the next line (fault candidate) (step S606).

After the processing of steps S603 to S606 is performed for all lines (all fault candidates) of the fault test candidate table, the test selection unit 101 ends this loop processing, and then performs similar processing regarding the next column (test case) recorded in the fault test candidate table (step S607). When the processing of steps S602 to S607 is performed for all columns (all test cases) recorded in the fault test candidate table, the calculation of the recovery cost expected value of the secondary fault regarding all test cases (entry in the recovery cost expected value 215B of the test priority table 215) is ended.

When the calculation of the recovery cost expected value of the secondary fault regarding all test cases recorded in the fault test candidate table in step S607 is completed, the test selection unit 101 performs the test priority determination processing for prioritizing the respective test cases (step S608), and then ends the test priority table creation processing.

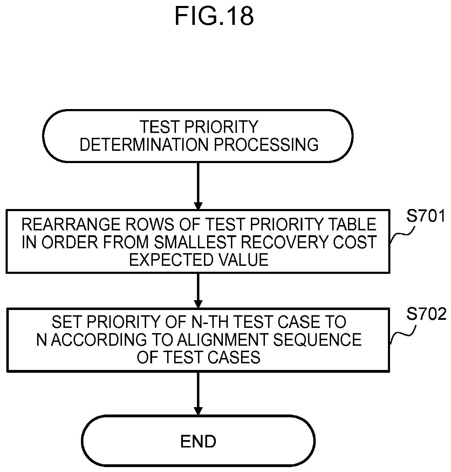

Fig. 18 is a flowchart showing an example of the processing routine of the test priority determination processing in the second embodiment. According to Fig. 18, the test selection unit 101 determines the priority based on the recovery cost expected value 215B of the secondary fault (refer to step S605 of Fig. 17) calculated for each test case regarding the respective test cases (test candidate 215A) recorded in the test priority table 215. Specifically, for instance, each column (test candidate 215A) of the test priority table 215 is rearranged in order from the lowest recovery cost expected value, and the test case with the lowest recovery cost expected value is moved to the left side (step S701).

Subsequently, the test selection unit 101 sets the priority 215C to "N" regarding the test candidate (test case) of the N-th column (N: integer) from the left of the test priority table 215 rearranged in step S601, and records the setting (step S602). The processing of step S602 is performed for all test candidates recorded in the test priority table 215, and, consequently, the priority of 1" to "N" will be assigned to all test candidates (test cases).

Accordingly, by performing the test priority table creation processing illustrated in Fig. 17 (including the test priority determination processing that was described in detail with reference to Fig. 18), the test selection unit 101 can create/update the test priority table 215 in which the unexecuted test cases have been prioritized in order from the unexecuted test case having the lowest recovery cost expected value of the secondary fault.

While the characteristic processing according to the second embodiment is as described above, in order to deepen the understanding thereof, a specific processing example up to the determination of the test priority of the first round test is now explained in comparison to the specific processing example explained in (1-4) of the first embodiment.

Foremost, while the test selection unit 101 acquires the fault injection test result table 213 and creates the fault test candidate table according to the flowchart of Fig. 8 in the same manner as the specific example of the first embodiment (step S101), because the result of a real machine test does not exist at such point in time, the entries of the fault test candidate table will remain unchanged even if the fault refinement processing (step S102) is performed. Moreover, because the fault test candidate table is still in the same state of being copied from the fault injection test result table 213, the four primary faults of "fault F1" to "fault F4" remain as the fault candidates (refer to Fig. 16), and the routine proceeds to the test priority table creation processing of step S105.

In the test priority table creation processing, the sum of the recovery cost expected values of the respective test cases is calculated (step S602 to S607). When the recovery cost expected value is specifically calculated based on the example of the fault injection test result table 213 illustrated in Fig. 16, foremost, because the secondary fault of the primary fault "fault F1" is "Yes" for the test case "TC1", the recovery cost expected value of "0.5" obtained by integrating the primary fault rate of "0.01" and the recovery cost of "50" is recorded in the recovery cost expected value 215B of the test priority table 215. Similarly, for the test case "TC2", the recovery cost expected value based on the primary fault "fault F3" becomes "0.3" as a result of the integration of "0.03 × 10", and this value is recorded in the test priority table 215. Moreover, for the test case "TC3", because there are the three primary faults of "fault F2 (primary fault rate 0.02, recovery cost 10)", "fault F3 (primary fault rate 0.03, recovery cost 30)", and "fault F4 (primary fault rate 0.40, recovery cost 20)" in which the secondary fault becomes "Yes", when the recovery cost expected value of each primary fault is calculated and added to the test priority table 215, the sum of the respective recovery cost expected values will ultimately become the recovery cost expected value of the test case "TC3". Specifically, the recovery cost expected value of "fault F2" becomes "0.2" based on the integration of "0.20 × 10", the recovery cost expected value of "fault F3" becomes "0.9" based on the integration of "0.30 × 30", and the recovery cost expected value of "fault F4" becomes "0.8" based on the integration of "0.40 × 20". Based on the calculation of the sum "0.2 + 0.9 + 0.8", "1.9" is recorded as the recovery cost expected value of the test case "TC3".

The test priority determination processing is subsequently performed based on the recovery cost expected value calculated in the manner described above. In the test priority determination processing, the test cases are rearranged in order from the test case having the smallest recovery cost expected value, and the priority is assigned in order from "1" to the rearranged test cases (steps S701, S702).

Fig. 19 is a diagram explaining an example of the test priority table in the second embodiment. Fig. 19 illustrates the test priority table 215 at the point in time that the processing of the first round test is completed based on foregoing specific processing example. According to the test priority table 215 of Fig. 19, the priority of "1" is assigned to the test case "TC2" because it has the smallest recovery cost expected value of "0.3", the priority of "2" is assigned to the test case "TC1" because it has the next smallest recovery cost expected value of "0.5", and the priority of "3" is assigned to the test case "TC3" because it has the largest recovery cost expected value of "1.9" with regard to the test candidate 215A of the test cases "TC1" to "TC3". Accordingly, as shown in the test priority table 215 of Fig. 19, as a result of the processing of the first round test being performed, the test case "TC2" having the smallest recovery cost expected value is selected as the test case to be subsequently executed.

Note that while the display of screens can also be performed by the screen display operation unit 103 in the second embodiment, because this can be realized in the same manner as the first embodiment, the explanation thereof is omitted.

As explained above, according to the hardware testing device 10 of the second embodiment, when performing a real machine test to the hardware to be tested 30 based on a plurality of test cases, even if there is a fault candidate in which a secondary fault may occur, it is possible to execute the real machine test based on a series of test cases while minimizing the expected value of the recovery cost resulting from the secondary fault by giving consideration to the probability of the secondary fault as well as to the recovery cost thereof.

In particular, in comparison to the effect yielded by the first embodiment, while the first embodiment determines the priority of the test cases based on the probability of the secondary fault, the second embodiment can create a test plan which minimizes the possibility of the secondary fault (influence resulting from the repair/recovery associated with the occurrence of a secondary fault) by giving consideration to the recovery cost associated with the occurrence of a secondary fault. Consequently, according to the second embodiment, it is possible to execute a real machine test that is even more efficient than the first embodiment.

Note that the present invention is not limited to each of the embodiments described above, and may be modified variously. For example, the foregoing embodiments were explained in detail for explaining the present invention in an easy-to-understand manner, and the present invention does not need to necessarily comprise all of the configurations explained in the embodiments. Moreover, a part of the configuration of a certain embodiment may be replaced with the configuration of another embodiment, and the configuration of another embodiment may be added to the configuration of one embodiment. Moreover, another configuration may be added to, deleted from or replaced with a part of the configuration of each embodiment.

Moreover, a part or all of the respective configurations, functions, processing units, and processing means described above may be realized with hardware such as by designing an integrated circuit. Moreover, the respective configurations and functions described above may also be realized with software by a processor interpreting and executing programs which realize the respective functions. Moreover, information of programs, tables and files for realizing the respective functions may be recorded in a memory, a hard disk, an SSD (Solid State Drive) or any other recording device, or may otherwise be recorded on an IC card, an SD card, a DVD or any other recording medium.

Moreover, control lines and information lines are indicated to the extent deemed required for the explanation, but not all control lines and information lines may have been indicated depending on the product. It should be considered that nearly all of the configurations are mutually connected for implementing the present invention.

### REFERENCE SIGNS LIST

10 Hardware testing device
11, 21 CPU
12, 22 Memory
13, 23 Storage
14 I/O interface
15 Input device
16 Output device
20 Simulation testing device
30 Hardware to be tested
40 Network
101 Test selection unit
102 Real machine testing unit
103 Screen display operation unit
111 Test list
112 Fault list
113 Fault injection test result table
114 Fault test candidate table
115, 215 Test priority table
116 Real machine test result table
160 Display screen
161 Real machine test result input area
162 Real machine test result registration button
163 Fault candidate display area
164 Test priority display area
201 Simulation testing unit
202 Hardware simulation device

## Claims

1. A hardware testing device (10) for conducting a test of hardware, comprising:
a test list (111) which describes a plurality of test cases to be executed in the hardware;
a fault list (112) which describes primary faults that may occur in the hardware and a fault rate of each of the primary faults, wherein a primary fault is a fault that exists in the hardware to be tested;
a simulation test result table which describes test results of simulation tests conducted by injecting the respective primary faults stored in the fault list (112) into the respective test cases described on the test list (111) in a simulated environment configured to simulate the hardware, and existence of any secondary faults, wherein a secondary fault is a fault generated when a primary fault exists and a test operation is performed;
a real machine testing unit (102) configured to execute a real machine test to the hardware based on the test cases; and
a test selection unit (101) configured to determine a test case to be subsequently executed by the real machine testing unit (102) among unexecuted test cases which are described in the test list (111) and in which the real machine test has not yet been executed by the real machine testing unit (102),
wherein the test selection unit (101) comprises:
a secondary fault calculation unit configured to calculate a parameter related to a secondary
fault for each of the unexecuted test cases based on contents of the simulation test result table and the fault list (112); and
a priority determination unit configured to determine a priority of the unexecuted test cases
based on the parameter related to the secondary fault calculated by the secondary fault calculation unit.

2. The hardware testing device (10) according to claim 1,
wherein the secondary fault calculation unit is configured to calculate, for each of the unexecuted test
cases, an occurrence rate of the secondary fault as a parameter related to the secondary fault of the unexecuted test case based on the primary fault which was injected in the simulation test that encountered the secondary fault among the simulation tests of the unexecuted test cases described in the simulation test result table and the fault rate of that primary fault described in the fault list (112).

3. The hardware testing device (10) according to claim 2, further comprising:
a real machine test result table (116) which stores test results of the real machine tests executed by the real machine testing unit (102),
wherein the secondary fault calculation unit is configured to calculate the occurrence rate of the secondary fault for each of the unexecuted test cases by excluding primary faults injected in the simulation tests in which tests results that differ from the test results stored in the latest real machine test result table (116) regarding the same test case are stored in the simulation test result table.

4. The hardware testing device (10) according to claim 3,
wherein the priority determination unit is configured to assign a higher priority to the unexecuted test
cases in order from the unexecuted test case having the lowest occurrence rate of the secondary fault calculated by the secondary fault calculation unit.

5. The hardware testing device (10) according to claim 1,
wherein the simulation test result table further includes a secondary fault recovery cost, and
wherein the secondary fault calculation unit is configured to calculate, for each of the unexecuted test cases, the secondary fault recovery cost as a parameter related to the secondary fault of the unexecuted test case based on the primary fault which was injected in the simulation test that encountered the secondary fault among the simulation tests of the unexecuted test cases described in the simulation test result table, the fault rate of that primary fault described in the fault list (112), and the secondary fault recovery cost.

6. The hardware testing device (10) according to claim 5,
wherein the priority determination unit is configured to assign a higher priority to the unexecuted test cases in order from the unexecuted test case having the smallest recovery cost expected value of the secondary fault calculated by the secondary fault calculation unit.

7. The hardware testing device (10) according to claim 1, further comprising:
a screen display operation unit (103) configured to output, to a predetermined output device (16), the test case determined by the test selection unit (101).

8. The hardware testing device (10) according to claim 7,
wherein the screen display operation unit (103) is configured to output the priority of the unexecuted test cases determined by the priority determination unit.

9. The hardware testing device (10) according to claim 7,
wherein the screen display operation unit (103) is configured to store, based on a predetermined input operation performed by a user who inputs a test result of the real machine test executed by the real machine testing unit (102), the input test result in the real machine test result table (116).

10. A hardware testing method performed by a hardware testing device which conducts a test of hardware,
wherein the hardware testing device includes:
a test list which describes a plurality of test cases to be executed in the hardware;
a fault list which describes primary faults that may occur in the hardware and a fault rate of each of the primary faults wherein a primary fault is a fault that exists in the hardware to be tested; and
a simulation test result table which describes test results of simulation tests conducted by injecting the respective primary faults stored in the fault list into the respective test cases described on the test list in a simulated environment simulating the hardware,
and existence of any secondary faults, wherein a secondary fault is a fault generated when a primary fault exists and a test operation is performed;
wherein hardware testing method comprises:
a real machine testing step of executing a real machine test to the hardware based on the test cases; and
a test selection step of determining a test case to be subsequently executed in the real machine testing step among unexecuted test cases which are described in the test list and in which the real machine test has not yet been executed in the real machine testing step,
wherein the test selection step further comprises:
a secondary fault calculation step of calculating parameters related to a secondary fault for each of the unexecuted test cases based on contents of the simulation test result table and the fault list; and
a priority determination step of determining a priority of the unexecuted test cases based on the parameter related to the secondary fault calculated in the secondary fault calculation step.

11. The hardware testing method according to claim 10,
wherein, in the secondary fault calculation step, for each of the unexecuted test cases, an occurrence rate of the secondary fault is calculated as a parameter related to the secondary fault of the unexecuted test case based on the primary fault which was injected in the simulation test that encountered the secondary fault among the simulation tests of the unexecuted test cases described in the simulation test result table and the fault rate of that primary fault described in the fault list.

12. The hardware testing method according to claim 10,
wherein the hardware testing device further includes:
a real machine test result table which stores test results of the real machine tests executed by the real machine testing unit,
wherein, in the secondary fault calculation step, the occurrence rate of the secondary fault is calculated for each of the unexecuted test cases by excluding primary faults injected in the simulation tests in which tests results that differ from the test results stored in the latest real machine test result table regarding the same test case are stored in the simulation test result table.

13. The hardware testing method according to claim 12,
wherein, in the priority determination step, a higher priority is assigned to the unexecuted test cases in order from the unexecuted test case having the lowest occurrence rate of the secondary fault calculated by the secondary fault calculation unit.

14. The hardware testing method according to claim 10,
wherein the simulation test result table further includes a secondary fault recovery cost,
and
wherein, in the secondary fault calculation step, for each of the unexecuted test cases,
the secondary fault recovery cost is calculated as a parameter related to the secondary fault of the unexecuted test case based on the primary fault which was injected in the simulation test that encountered the secondary fault among the simulation tests of the unexecuted test cases described in the simulation test result table, the fault rate of that primary fault described in the fault list, and the secondary fault recovery cost.

15. The hardware testing method according to claim 14,
wherein, in the priority determination step, a higher priority to the unexecuted test cases in order from the unexecuted test case having the smallest recovery cost expected value of the secondary fault calculated by the secondary fault calculation unit.

## Patentansprüche

1. Hardware-Testvorrichtung (10) zur Durchführung eines Tests von Hardware, umfassend:
eine Testliste (111), die eine Vielzahl von in der Hardware auszuführenden Testfällen beschreibt;
eine Fehlerliste (112), die Primärfehler, die in der Hardware auftreten können, und eine Fehlerrate jedes der Primärfahler beschreibt, wobei ein Primärfehler ein Fehler ist, der in der zu testenden Hardware vorliegt;
eine Simulationstestergebnistabelle, die Testergebnisse von Simulationstests, die durch Einführen der jeweiligen in der Fehlerliste (112) gespeicherten Primärfehler in die jeweiligen auf der Testliste (111) beschriebenen Testfälle in einer zum Simulieren der Hardware konfigurierten simulierten Umgebung durchgeführt werden, und das Vorliegen jeglicher Sekundärfehler beschreibt, wobei ein Sekundärfehler ein Fehler ist, der erzeugt wird, wenn ein Primärfehler vorliegt und ein Testvorgang durchgeführt wird;
eine Reale-Maschinen-Testeinheit (102), die konfiguriert ist, um basierend auf den Testfällen einen Reale-Maschinen-Test an der Hardware auszuführen; und
eine Testauswahleinheit (101), die konfiguriert ist, um einen Testfall zu bestimmen, der daraufhin unter nicht ausgeführten Testfällen, die in der Testliste (111) beschrieben sind und bei denen der Reale-Maschinen-Test noch nicht durch die Reale-Maschinen-Testeinheit (102) ausgeführt worden ist, durch die Reale-Maschinen-Testeinheit (102) auszuführen ist, wobei die Testauswahleinheit (101) Folgendes umfasst:
eine Sekundärfehlerberechnungseinheit, die konfiguriert ist, um einen Parameter bezogen auf einen Sekundärfehler für jeden der nicht ausgeführten Testfälle basierend auf Inhalten der Simulationstestergebnistabelle und der Fehlerliste (112) zu berechnen; und
eine Prioritätsbestimmungseinheit, die konfiguriert ist, um eine Priorität der nicht ausgeführten Testfälle basierend auf dem Parameter bezogen auf den Sekundärfehler, der durch die Sekundärfehlerberechnungseinheit berechnet wird, zu bestimmen.

2. Hardware-Testvorrichtung (10) nach Anspruch 1,
wobei die Sekundärfehlerberechnungseinheit konfiguriert ist, um für jeden der nicht ausgeführten Testfälle eine Häufigkeitsrate des Sekundärfehlers als Parameter bezogen auf den Sekundärfehler des nicht ausgeführten Testfalls zu berechnen, und zwar basierend auf dem Primärfehler, der in dem Simulationstest eingeführt wurde, der unter den Simulationstests der nicht ausgeführten Testfälle, die in der Simulationstestergebnistabelle beschrieben sind, den Sekundärfehler feststellte, und der Fehlerrate des in der Fehlerliste (112) beschriebenen Primärfehlers.

3. Hardware-Testvorrichtung (10) nach Anspruch 2, ferner umfassend:
eine Reale-Maschinen-Testergebnistabelle (116), die Testergebnisse der durch die Reale-Maschinen-Testeinheit (102) ausgeführten Reale-Maschinen-Tests speichert,
wobei die Sekundärfehlerberechnungseinheit konfiguriert ist, um die Häufigkeitsrate des Sekundärfehlers für jeden der nicht ausgeführten Testfälle zu berechnen, und zwar durch Ausschließen von Primärfehlern, die in den Simulationstests eingeführt werden, bei denen Testergebnisse, die sich von den in der aktuellsten Reale-Maschinen-Testergebnistabelle (116) gespeicherten Testergebnissen in Bezug auf denselben Testfall unterscheiden, in der Simulationstestergebnistabelle gespeichert sind.

4. Hardware-Testvorrichtung (10) nach Anspruch 3,
wobei die Prioritätsbestimmungseinheit konfiguriert ist, um den nicht ausgeführten Testfällen eine höhere Priorität zuzuweisen, und zwar in einer Reihenfolge ausgehend von dem nicht ausgeführten Testfall mit der niedrigsten Häufigkeitsrate des Sekundärfehlers, der durch die Sekundärfehlerberechnungseinheit berechnet wird.

5. Hardware-Testvorrichtung (10) nach Anspruch 1,
wobei die Simulationstestergebnistabelle ferner Sekundärfehlerwiederherstellungskosten umfasst und
wobei die Sekundärfehlerberechnungseinheit konfiguriert ist, um für jeden der nicht ausgeführten Testfälle die Sekundärfehlerwiederherstellungskosten als Parameter bezogen auf den Sekundärfehler des nicht ausgeführten Testfalls, und zwar basierend auf dem Primärfehler, der in dem Simulationstest eingeführt wurde, der unter den Simulationstests der nicht ausgeführten Testfälle, die in der Simulationstestergebnistabelle beschrieben sind, den Sekundärfehler feststellte, die Fehlerrate des in der Fehlerliste (112) beschriebenen Primärfehlers und die Sekundärfehlerwiederherstellungskosten zu berechnen.

6. Hardware-Testvorrichtung (10) nach Anspruch 5,
wobei die Prioritätsbestimmungseinheit konfiguriert ist, um den nicht ausgeführten Testfällen eine höhere Priorität zuzuweisen, und zwar in einer Reihenfolge ausgehend von dem nicht ausgeführten Testfall mit dem niedrigsten Wiederherstellungskosten-Erwartungswert des Sekundärfehlers, der durch die Sekundärfehlerberechnungseinheit berechnet wird.

7. Hardware-Testvorrichtung (10) nach Anspruch 1, ferner umfassend:
eine Bildschirmanzeigebetriebseinheit (103), die konfiguriert ist, um den durch die Testauswahleinheit (101) bestimmten Testfall an eine vorbestimmte Ausgabevorrichtung (16) auszugeben.

8. Hardware-Testvorrichtung (10) nach Anspruch 7,
wobei die Bildschirmanzeigebetriebseinheit (103) konfiguriert ist, um die durch die Prioritätsbestimmungseinheit bestimmte Priorität der nicht ausgeführten Testfälle auszugeben.

9. Hardware-Testvorrichtung (10) nach Anspruch 7,
wobei die Bildschirmanzeigebetriebseinheit (103) konfiguriert ist, um basierend auf einem vorbestimmten Eingabevorgang, der von einem Benutzer durchgeführt wird, der ein Testergebnis des durch die Reale-Maschinen-Testeinheit (102) ausgeführten Reale-Maschinen-Tests eingibt, das Eingabetestergebnis in der Reale-Maschinen-Testergebnistabelle (116) zu speichern.

10. Hardware-Testverfahren, das durch eine Hardware-Testvorrichtung durchgeführt wird, die einen Test von Hardware vornimmt,
wobei die Hardware-Testvorrichtung Folgendes umfasst:
eine Testliste, die eine Vielzahl von in der Hardware auszuführenden Testfällen beschreibt;
eine Fehlerliste, die Primärfehler, die in der Hardware auftreten können, und eine Fehlerrate jedes der Primärfahler beschreibt, wobei ein Primärfehler ein Fehler ist, der in der zu testenden Hardware vorliegt; und
eine Simulationstestergebnistabelle, die Testergebnisse von Simulationstests, die durch Einführen der jeweiligen in der Fehlerliste gespeicherten Primärfehler in die jeweiligen auf der Testliste beschriebenen Testfälle in einer simulierten Umgebung, die die Hardware simuliert, durchgeführt werden, und das Vorliegen jeglicher Sekundärfehler beschreibt, wobei ein Sekundärfehler ein Fehler ist, der erzeugt wird, wenn ein Primärfehler vorliegt und ein Testvorgang durchgeführt wird;
wobei das Hardware-Testverfahren Folgendes umfasst:
einen Reale-Maschinen-Testschritt des Ausführens eines Reale-Maschinen-Tests an der Hardware basierend auf den Testfällen; und
einen Testauswahlschritt des Bestimmens eines Testfalls, der unter nicht ausgeführten Testfällen, die in der Testliste beschrieben sind und bei denen der Reale- Maschinen-Test in dem Reale-Maschinen-Testschritt noch nicht ausgeführt worden ist, daraufhin in dem Reale-Maschinen-Testschritt auszuführen ist,
wobei der Testauswahlschritt ferner Folgendes umfasst:
einen Sekundärfehlerberechnungsschritt des Berechnens von Parametern bezogen auf einen Sekundärfehler für jeden der nicht ausgeführten Testfälle basierend auf Inhalten der Simulationstestergebnistabelle und der Fehlerliste; und
einen Prioritätsbestimmungsschritt des Bestimmens einer Priorität der nicht ausgeführten Testfälle basierend auf dem Parameter bezogen auf den Sekundärfehler, der in dem Sekundärfehlerberechnungsschritt berechnet wird.

11. Hardware-Testverfahren nach Anspruch 10,
wobei in dem Sekundärfehlerberechnungsschritt für jeden der nicht ausgeführten Testfälle eine Häufigkeitsrate des Sekundärfehlers als Parameter bezogen auf den Sekundärfehler des nicht ausgeführten Testfalls berechnet wird, und zwar basierend auf dem Primärfehler, der in dem Simulationstest eingeführt wurde, der unter den Simulationstests der nicht ausgeführten Testfälle, die in der Simulationstestergebnistabelle beschrieben sind, den Sekundärfehler feststellte, und der Fehlerrate des in der Fehlerliste beschriebenen Primärfehlers.

12. Hardware-Testverfahren nach Anspruch 10,
wobei die Hardware-Testvorrichtung ferner Folgendes umfasst:
eine Reale-Maschinen-Testergebnistabelle, die Testergebnisse der Reale- Maschinen-Tests, die durch die Reale-Maschinen-Testeinheit ausgeführt werden, speichert,
wobei in dem Sekundärfehlerberechnungsschritt die Häufigkeitsrate des Sekundärfehlers für jeden der nicht ausgeführten Testfälle berechnet wird, und zwar durch Ausschließen von Primärfehlern, die in den Simulationstests eingeführt werden, bei denen Testergeb-nisse, die sich von den in der aktuellsten Reale-Maschinen-Testergebnistabelle gespeicherten Testergebnissen in Bezug auf denselben Testfall unterscheiden, in der Simulationstestergebnistabelle gespeichert werden.

13. Hardware-Testverfahren nach Anspruch 12,
wobei in dem Prioritätsbestimmungsschritt den nicht ausgeführten Testfällen eine höhere Priorität zugewiesen wird, und zwar in einer Reihenfolge ausgehend von dem nicht ausgeführten Testfall mit der niedrigsten Häufigkeitsrate des Sekundärfehlers, der durch die Sekundärfehlerberechnungseinheit berechnet wird.

14. Hardware-Testverfahren nach Anspruch 10,
wobei die Simulationstestergebnistabelle ferner Sekundärfehlerwiederherstellungskosten umfasst und
wobei in dem Sekundärfehlerberechnungsschritt für jeden der nicht ausgeführten Testfälle die Sekundärfehlerwiederherstellungskosten als Parameter bezogen auf den Sekundärfehler des nicht ausgeführten Testfalls, und zwar basierend auf dem Primärfehler, der in dem Simulationstest eingeführt wurde, der unter den Simulationstests der nicht ausgeführten Testfälle, die in der Simulationstestergebnistabelle beschrieben sind, den Sekundärfehler feststellte, die Fehlerrate des in der Fehlerliste beschriebenen Primärfehlers und die Sekundärfehlerwiederherstellungskosten berechnet werden.

15. Hardware-Testverfahren nach Anspruch 14,
wobei in dem Prioritätsbestimmungsschritt den nicht ausgeführten Testfällen eine höhere Priorität zugewiesen wird, und zwar in einer Reihenfolge ausgehend von dem nicht ausgeführten Testfall mit dem niedrigsten Wiederherstellungskosten-Erwartungswert des Sekundärfehlers, der durch die Sekundärfehlerberechnungseinheit berechnet wird.

## Revendications

1. Dispositif de test de matériel (10) pour effectuer un test de matériel, comprenant :
une liste de tests (111) qui décrit une pluralité de cas de test à exécuter dans le matériel ;
une liste de défauts (112) qui décrit des défauts principaux qui peuvent survenir dans le matériel et un taux de défaillance de chacun des défauts principaux, dans lequel un défaut principal est un défaut qui existe dans le matériel à tester ;
un tableau de résultats de tests de simulation qui décrit des résultats de test de tests de simulation effectués en injectant les défauts principaux respectifs stockés dans la liste de défauts (112) dans les cas de test respectifs décrits sur la liste de tests (111) dans un environnement simulé configuré pour simuler le matériel, et l'existence de quelconques défauts secondaires, dans lequel un défaut secondaire est un défaut généré lorsqu'un défaut principal existe et qu'une opération de test est effectuée ;
une unité de test de machine réelle (102) configurée pour exécuter un test de machine réelle sur le matériel sur la base des cas de test ; et
une unité de sélection de test (101) configurée pour déterminer un cas de test à exécuter ultérieurement par l'unité de test de machine réelle (102) parmi des cas de test non exécutés qui sont décrits dans la liste de test (111) et dans lesquels le test de machine réelle n'a pas encore été exécuté par l'unité de test de machine réelle (102),
dans lequel l'unité de sélection de test (101) comprend :
une unité de calcul de défaut secondaire configurée pour calculer un paramètre lié à un défaut secondaire pour chacun des cas de test non exécutés sur la base de contenus du tableau de résultats de tests de simulation et de la liste de défauts (112) ; et
une unité de détermination de priorité configurée pour déterminer une priorité des cas de test non exécutés sur la base du paramètre lié au défaut secondaire calculé par l'unité de calcul de défaut secondaire.

2. Dispositif de test de matériel (10) selon la revendication 1,
dans lequel l'unité de calcul de défaut secondaire est configurée pour calculer, pour chacun des cas de test non exécutés, un taux d'occurrence du défaut secondaire en tant que paramètre lié au défaut secondaire du cas de test non exécuté sur la base du défaut principal qui a été injecté dans la simulation de test ayant rencontré le défaut secondaire parmi les tests de simulation des cas de test non exécutés décrits dans le tableau de résultats de tests de simulation et du taux de défaillance de ce défaut principal décrit dans la liste des défauts (112).

3. Dispositif de test de matériel (10) selon la revendication 2, comprenant en outre :
une table de résultats de tests de machine réelle (116) qui stocke les résultats de test des tests de machine réelle exécutés par l'unité de test de machine réelle (102),
dans lequel l'unité de calcul de défaut secondaire est configurée pour calculer le taux d'occurrence du défaut secondaire pour chacun des cas de test non exécutés en excluant des défauts principaux injectés dans les tests de simulation dans lesquels des résultats de test diffèrent des résultats de test stockés dans le dernier tableau de résultats de tests de machine réelle (116) concernant le même cas de test sont stockés dans le tableau de résultats de test de simulation.

4. Dispositif de test de matériel (10) selon la revendication 3,
dans lequel l'unité de détermination de priorité est configurée pour attribuer une priorité plus élevée aux cas de test non exécutés dans l'ordre à partir du cas de test non exécuté ayant le taux d'occurrence le plus faible du défaut secondaire calculé par l'unité de calcul de défaut secondaire.

5. Dispositif de test de matériel (10) selon la revendication 1,
dans lequel le tableau de résultats de tests de simulation comprend en outre un coût de correction de défaut secondaire, et
dans lequel l'unité de calcul de défaut secondaire est configurée pour calculer, pour chacun des cas de test non exécutés, le coût de correction de défaut secondaire en tant que paramètre lié au défaut secondaire du cas de test non exécuté sur la base du défaut principal qui a été injecté dans le test de simulation qui a rencontré le défaut secondaire parmi les tests de simulation des cas de test non exécutés décrits dans le tableau de résultats de tests de simulation, du taux de défaillance de ce défaut principal décrit dans la liste de défauts (112) et du coût de correction de défaut secondaire.

6. Dispositif de test de matériel (10) selon la revendication 5,
dans lequel l'unité de détermination de priorité est configurée pour attribuer une priorité plus élevée aux cas de test non exécutés dans l'ordre à partir du cas de test non exécuté ayant la plus petite valeur attendue de coût de correction de défaut secondaire calculée par l'unité de calcul de défaut secondaire.

7. Dispositif de test de matériel (10) selon la revendication 1, comprenant en outre :
une unité d'opération d'affichage d'écran (103) configurée pour délivrer en sortie, vers un dispositif de sortie prédéterminé (16), le cas de test déterminé par l'unité de sélection de test (101).

8. Dispositif de test de matériel (10) selon la revendication 7,
dans lequel l'unité d'opération d'affichage d'écran (103) est configurée pour délivrer en sortie la priorité des cas de test non exécutés déterminée par l'unité de détermination de priorité.

9. Dispositif de test de matériel (10) selon la revendication 7,
dans lequel l'unité d'opération d'affichage d'écran (103) est configurée pour stocker, sur la base d'une opération d'entrée prédéterminée effectuée par un utilisateur qui entre un résultat de test du test de machine réelle exécuté par l'unité de test de machine réelle (102), le résultat de test d'entrée dans le tableau de résultats de tests de machine réelle (116).

10. Procédé de test de matériel effectué par un dispositif de test de matériel qui effectue un test de matériel,
dans lequel le dispositif de test de matériel comprend :
une liste de tests qui décrit une pluralité de cas de test à exécuter dans le matériel ;
une liste de défauts qui décrit des défauts principaux qui peuvent survenir dans le matériel et un taux de défaillance de chacun des défauts principaux, dans lequel un défaut principal est un défaut qui existe dans le matériel à tester ; et
un tableau de résultats de tests de simulation qui décrit des résultats de test de tests de simulation effectués en injectant les défauts principaux respectifs stockés dans la liste de défauts dans les cas de test respectifs décrits sur la liste de tests dans un environnement simulé simulant le matériel, et l'existence de quelconques défauts secondaires, dans lequel un défaut secondaire est un défaut généré lorsqu'un défaut principal existe et qu'une opération de test est effectuée ;
dans lequel le procédé de test de matériel comprend :
une étape de test de machine réelle consistant à exécuter un test de machine réelle sur le matériel sur la base des cas de test ; et
une étape de sélection de test pour déterminer un cas de test à exécuter ultérieurement dans l'étape de test de machine réelle parmi des cas de test non exécutés qui sont décrits dans la liste de tests et dans lesquels le test de machine réelle n'a pas encore été exécuté dans l'étape de test de machine réelle,
dans lequel l'étape de sélection de test comprend en outre :
une étape de calcul de défaut secondaire consistant à calculer des paramètres liés à un défaut secondaire pour chacun des cas de test non exécutés sur la base de contenus du tableau de résultats de tests de simulation et de la liste de défauts ; et
une étape de détermination de priorité pour déterminer une priorité des cas de test non exécutés sur la base du paramètre lié au défaut secondaire calculé lors de l'étape de calcul de défaut secondaire.

11. Procédé de test de matériel selon la revendication 10,
dans lequel, lors de l'étape de calcul de défaut secondaire, pour chacun des cas de test non exécutés, un taux d'occurrence du défaut secondaire est calculé en tant que paramètre lié au défaut secondaire du cas de test non exécuté sur la base du défaut principal qui a été injecté dans le test de simulation ayant rencontré le défaut secondaire parmi les tests de simulation des cas de test non exécutés décrits dans le tableau de résultats de tests de simulation et du taux de défaillance de ce défaut principal décrit dans la liste de défauts.

12. Procédé de test de matériel selon la revendication 10,
dans lequel le dispositif de test de matériel comprend en outre :
un tableau de résultats de tests de machine réelle qui stocke de résultats de test des tests de machine réelle exécutés par l'unité de test de machine réelle,
dans lequel, lors de l'étape de calcul de défaut secondaire, le taux d'occurrence du défaut secondaire est calculé pour chacun des cas de test non exécutés en excluant des défauts principaux injectés dans les tests de simulation dans lesquels les résultats de tests qui diffèrent des résultats de tests stockés dans le dernier tableau de résultats de tests de machine réelle concernant le même cas de test sont stockés dans le tableau de résultats de tests de simulation.

13. Procédé de test de matériel selon la revendication 12,
dans lequel, lors de l'étape de détermination de priorité, une priorité plus élevée est attribuée aux cas de test non exécutés dans l'ordre à partir du cas de test non exécuté ayant le taux d'occurrence le plus faible du défaut secondaire calculé par l'unité de calcul de défaut secondaire.

14. Procédé de test de matériel selon la revendication 10,
dans lequel le tableau de résultats de tests de simulation comprend en outre un coût de correction de défaut secondaire, et
dans lequel, lors de l'étape de calcul de défaut secondaire, pour chacun des cas de test non exécutés, le coût de correction de défaut secondaire est calculé comme un paramètre lié au défaut secondaire du cas de test non exécuté sur la base du défaut principal qui a été injecté dans le test de simulation qui a rencontré le défaut secondaire parmi les tests de simulation des cas de test non exécutés décrits dans le tableau de résultats de tests de simulation, du taux de défaillance de ce défaut principal décrit dans la liste de défauts et du coût de correction de défaut secondaire.

15. Procédé de test de matériel selon la revendication 14,
dans lequel, dans l'étape de détermination de la priorité, une priorité plus élevée aux cas de test non exécutés dans l'ordre à partir du cas de test non exécuté ayant la plus petite valeur attendue de coût de correction de défaut secondaire calculée par l'unité de calcul de défaut secondaire.
